(19) Europäisches Patentamt
European Patent Office
Office européen des brevets

(11) **EP 1 264 458 B1**

(12) **EUROPÄISCHE PATENTSCHRIFT**

(45) Veröffentlichungstag und Bekanntmachung des Hinweises auf die Patenterteilung:
**23.02.2005 Patentblatt 2005/08**

(51) Int Cl.$^7$: **H04L 27/36**

(21) Anmeldenummer: 01913845.2

(22) Anmeldetag: **02.03.2001**

(86) Internationale Anmeldenummer:
**PCT/EP2001/002381**

(87) Internationale Veröffentlichungsnummer:
**WO 2001/069879 (20.09.2001 Gazette 2001/38)**

(54) **DIGITALER I/Q-MODULATOR MIT VORVERZERRUNG**

DIGITAL I/Q MODULATOR HAVING A PREDISTORSION

MODULATEUR I/Q NUMERIQUE A PREDISTORSION

(84) Benannte Vertragsstaaten:
**DE FI FR GB SE**

(30) Priorität: **15.03.2000 DE 10012538**

(43) Veröffentlichungstag der Anmeldung:
**11.12.2002 Patentblatt 2002/50**

(73) Patentinhaber: **Fraunhofer-Gesellschaft zur Förderung der angewandten Forschung e.V. 80686 München (DE)**

(72) Erfinder:
• **GAMM, Eberhard**
  **91052 Erlangen (DE)**

• **RETKOWSKI, Reiner**
  **91054 Erlangen (DE)**
• **ULBRICHT, Gerald**
  **90552 Röthenbach (DE)**
• **GERHÄUSER, Heinz**
  **91344 Waischenfeld (DE)**

(74) Vertreter: **Schoppe, Fritz, Dipl.-Ing.
Patentanwälte Schoppe, Zimmermann,
Stöckeler & Zinkler,
Postfach 246
82043 Pullach bei München (DE)**

(56) Entgegenhaltungen:
**EP-A- 0 982 849          WO-A-99/66637**

EP 1 264 458 B1

**Beschreibung**

Die vorliegende Erfindung bezieht sich auf einen I/Q-Modulator und insbesondere auf einen I/Q-Modulator zum Verarbeiten eines zeitdiskreten I/Q-Signals.

Herkömmliche I/Q-Modulatoren werden in Sendeeinrichtungen für trägerfrequente Übertragungssysteme, z. B. Sendern für den digitalen Rundfunk und in Basisstationen für die Mobilkommunikation, eingesetzt.

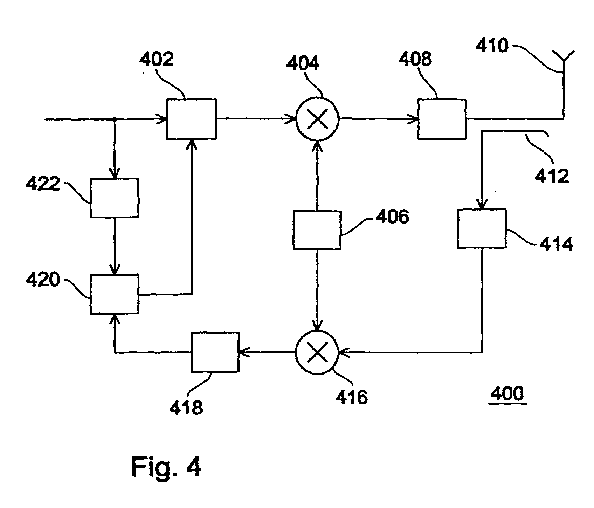

Ein Beispiel einer derartigen Sendeeinrichtung ist in Fig. 4 gezeigt. Die Sendeeinrichtung 400 umfaßt einen I/Q-Modulator 402 mit Vorverzerrung, der einen ersten Eingang, der mit dem eingang der Sendeeinrichtung 400 verbunden ist, und einen Ausgang aufweist. An dem ersten Eingang des I/Q-Modulators ist ein I/Q-Signal angelegt. Der Ausgang des I/Q-Modulators ist mit einem ersten Eingang eines ersten Mischers 404 verbunden. Ein zweiter Eingang 404 des Mischers ist mit einem Oszillator 406 verbunden. Ein Ausgang des Mischers 404 ist mit einem Eingang eines Verstärkers 408 verbunden. Ein Ausgang des Verstärkers 408 ist mit einer Antenne 410 verbunden. Zwischen dem Verstärker 408 und der Antenne 410 ist eine Auskopplungseinrichtung 412 angeordnet, die mit dem Eingang eines Dämpfungsglieds 414 verbunden ist. Ein Ausgang des Dämpfungsglieds 414 ist mit einem ersten Eingang eines zweiten Mischers 416 verbunden. Ein zweiter Eingang des zweiten Mischers 416 ist mit dem Oszillator 406 verbunden. Ein Ausgang des Mischers 416 ist mit einem Eingang eines I/Q-Demodulators 418 verbunden. Ein Ausgang des I/Q-Demodulators 418 ist mit einem ersten Eingang einer Vergleichseinrichtung 420 verbunden. Ein zweiter Eingang der Vergleichseinrichtung 420 ist mit einem Ausgang eines Verzögerungsglieds 422 verbunden. Ein Ausgang der Vergleichseinrichtung 420 ist mit einem zweiten Eingang des I/Q-Modulators 402 verbunden. Ein Eingang des Verzögerungsglieds 422 ist mit dem ersten Eingang des I/Q-Modulators 402 verbunden. Die Auskopplungseinrichtung 412, das Dämpfungsglied 414, der zweite Mischer 416, der I/Q-Demodulator 418 und die Vergleichseinrichtung 420 bilden eine Rückführung zur Bestimmung der Vorverzerrungsparameter.

Im folgenden ist kurz die Funktionsweise einer Sendeeinrichtung gemäß Fig. 4 beschrieben. Ein I/Q-Signal, das beispielsweise ein nachrichtentragendes Basisbandsignal mit einer I- und einer Q-Komponente ist, wird durch den I/Q-Modulator auf ein Trägersignal moduliert. Um Verzerrungen des ersten Mischers 404 und des Verstärkers 408 zu kompensieren, führt der I/Q-Modulator neben der Modulation ferner eine Vorverzerrung des I/Q-Signals durch. Dies ist insbesondere bei der Verwendung von Sendesignalen mit nicht-konstanten Einhüllenden wichtig. Diese treten beispielsweise auf, wenn amplitudenmodulierte Signale anstatt frequenzmodulierten Signalen verwendet werden, um eine höhere spektrale Effizienz des Modulationsverfahrens zu erreichen. Die nicht-konstante Einhüllende des Sendesignals verursacht in Verbindung mit den Nicht-Linearitäten des ersten Mischers 404 und des Verstärkers 408 Störungen außerhalb des Nutzfrequenzbandes. Diese Störungen werden Nachbarkanalaussendung genannt und dürfen typischerweise einen anwendungsspezifischen Grenzwert nicht überschreiten.

Das vorverzerrte Ausgangssignal des I/Q-Modulators 402 läuft in den ersten Mischer 404, in dem das Signal mit Hilfe des Oszillators 406 aufwärts gemischt wird. Das aufwärts gemischte Signal wird dann durch den Verstärker 408, z. B. eine Wanderfeldröhre, verstärkt und auf die Antenne 410 geschickt und ausgesendet.

Ein Teil des zu der Antenne 410 geschickten Signals wird vorher durch die Auskopplungseinrichtung 412 abgezweigt und für eine weitere Verarbeitung durch das Dämpfungsglied 414 gedämpft, um die Wirkung der Verstärkung des Verstärkers 408 rückgängig zu machen. Das abgeweigte gedämpfte Signal läuft in den zweiten Mischer 416, um abwärts gemischt zu werden. Das abwärts gemischte Signal läuft in den I/Q-Demodulator, um in ein I/Q-Signal demoduliert zu werden. Das demodulierte I/Q-Signal trägt jetzt die Informationen über die Verzerrung des ursprünglichen I/Q-Signals durch den ersten Mischer 404 und den Verstärker 408. Wird dieses demodulierte verzerrte I/Q-Signal der Vergleichseinrichtung 420 zugeführt, so liefert der Vergleich des ursprünglichen I/Q-Signals mit dem verzerrten I/Q-Signal die Informationen darüber, wie die Vorverzerrung des I/Q-Moduiators gewählt werden muß, so daß die Verzerrungen, die durch den ersten Mischer 404 und den Verstärker 408 verursacht werden, optimal ausgeglichen werden können.

Ein wichtiges Merkmal für den Vergleich ist dabei, daß das ursprüngliche I/Q-Signal durch das Verzögerungsglied 422 vor dem Vergleich in der Vergleichseinrichtung 420 zeitlich verzögert wird, damit das ursprüngliche I/Q-Signal tatsächlich jenes Signal ist, das das vorverzerrte I/Q-Signal bewirkt hat. Dieses Verfahren des von einem Vergleich abhängigen Einstellens der Vorverzerrung des I/Q-Modulators 402 wird adaptive Vorverzerrung genannt.

Ein Beispiel einer derartigen adaptiven Vorverzerrung ist in der US-5,049,832 beschrieben. Die US-5,049,832 offenbart eine Verstärkerlinearisierung einer Verstärkerschaltung durch adaptive Vorverzerrung, bei der ein Eingangssignal für einen Leistungsverstärker der Verstärkerschaltung aus einem Eingangsmodulationssignal der Verstärkerschaltung durch Vorverzerrung abgeleitet wird, d. h. das Eingangssignal des Leistungsverstärkers ist vorverzerrt, um zu erreichen, daß dasselbe durch den Leistungsverstärker linear verstärkt wird.

Die Vorverzerrung des Eingangsmodulationssignals wird dabei über eine Tabelle, die abhängig von dem Amplitudenquadrat des Eingangsmodulationssignals adressiert wird, eingestellt, wobei die Inhalte der Tabelle fortdauernd aktualisiert werden, um Variationen der Verzerrung durch den Leistungsverstärker bei der Vorverzerrung des Eingangsmodulationsignals durch die Tabelle zu berücksichtigen.

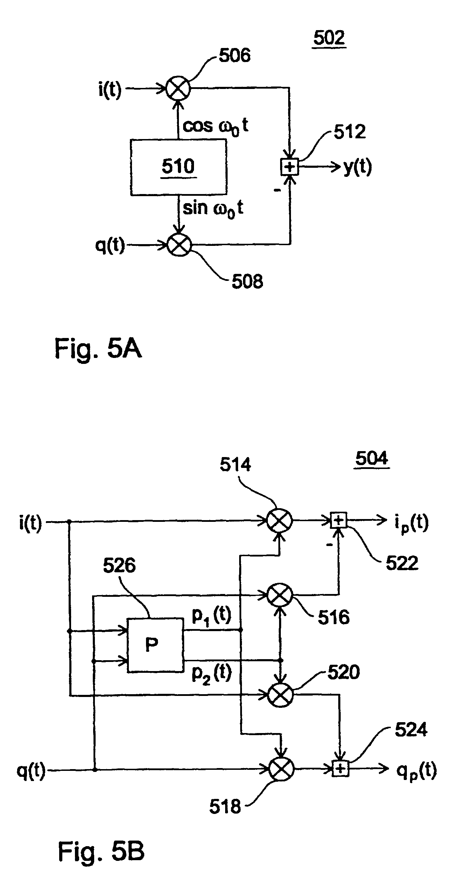

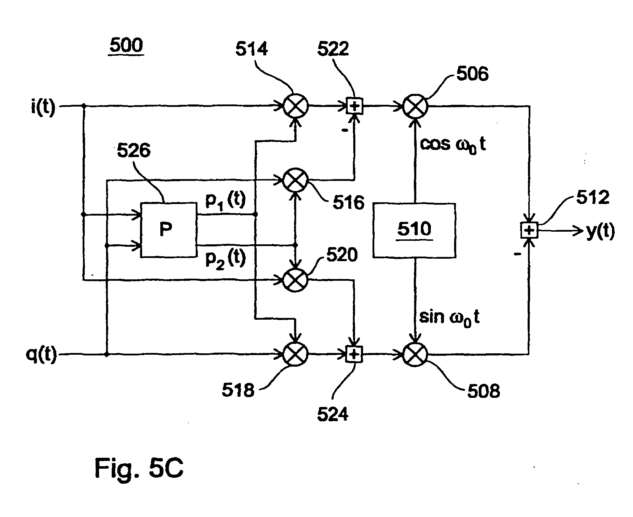

Fig. 5A und B zeigen die Komponenten und Fig. 5C den Gesamtaufbau eines herkömmlichen I/Q-Modulators 500 mit Vorverzerrung des I/Q-Signals bzw. des Basisbandsignals.

Fig. 5A zeigt eine Einrichtung 502 zum Aufbringen eines I/Q-Signals bzw. eines Basisbandsignals, das eine I-Komponente und eine Q-Komponente aufweist, auf einem Trägersignal, das eine erste Teilkomponente, hier eine Sinus-Komponente, und eine dazu im wesentlichen orthogonale Teilkomponente, hier eine Cosinus-Komponente, aufweist, um ein Ausgangssignal y(t) zu erzeugen.

$$y(t) = i(t) \cdot \cos\omega_0 t - q(t) \cdot \sin\omega_0 t \text{ mit } \omega_0 = 2\pi f_0 \qquad \text{Glg. 1}$$

Die Einrichtung 502 zum Aufbringen eines I/Q-Signals auf einem Trägersignal weist einen ersten Multiplizierer 506, einen zweiten Multiplizierer 508, eine Einrichtung 510 zum Erzeugen eines Trägersignals und einen Addierer 512 auf.

Der erste Multiplizierer 506 weist einen ersten Eingang, der ein erster Eingang der Einrichtung 502 zum Aufbringen eines I/Q-Signals auf einem Trägersignal ist, an dem die I-Komponente des I/Q-Signals angelegt ist, einen zweiten Eingang, der mit einem ersten Ausgang der Einrichtung 510 zum Erzeugen eines Trägersignals verbunden ist, und einen Ausgang auf, der mit einem ersten Eingang des Addierers 512 verbunden ist.

Der zweite Multiplizierer 508 weist einen ersten Eingang, der ein zweiter Eingang der Einrichtung 502 zum Aufbringen eines I/Q-Signals auf einem Trägersignal ist, an dem die Q-Komponente des I/Q-Signals angelegt ist, einen zweiten Eingang, der mit einem zweiten Ausgang der Einrichtung 510 zum Erzeugen eines Trägersignals verbunden ist, und einen Ausgang auf, der mit einem invertierenden zweiten Eingang des Addierers 512 verbunden ist.

Die Einrichtung 510 zum Erzeugen eines Trägersignals erzeugt ein Trägersignal, das komplex wie folgt dargestellt werden kann:

$$e^{j\omega_0 t} = \cos\omega_0 t + j \sin\omega_0 t \qquad \text{Glg. 2}$$

Der erste Multiplizierer 506 multipliziert die erste Teilkomponente des Trägersignals mit der I-Komponente des I/Q-Signals, wie es die erste Multiplikation von Gleichung 1 zeigt, um eine multiplizierte I-Komponente zu erhalten, und der zweite Multiplizierer 508 multipliziert die zweite Teilkomponente des Trägersignals mit der Q-Komponente des I/Q-Signals, um eine multiplizierte Q-Komponente zu erhalten, wie es die zweite Multiplikation von Gleichung 1 zeigt.

Der Addierer 512 bildet folgend dem ersten Multiplizierer 506 und dem zweiten Multiplizierer 508 die Differenz der multiplizierten I-Komponente und der multiplizierten Q-Komponente, wie es in Glg. 1 gezeigt ist, um das Ausgangssignal y(t) der Einrichtung 502 zum Aufbringen eines I/Q-Signals auf einem Trägersignal zu erzeugen.

Das I/Q-Signal wird nun ebenfalls komplex dargestellt.

$$\underline{x}(t) = i(t) + jq(t) \qquad \text{Glg. 3}$$

Die Funktion der Einrichtung 502 zum Aufbringen eines I/Q-Signals auf einem Trägersignal kann dann durch folgende komplexe Darstellung beschrieben werden:

$$y(t) = \text{Re}\{\underline{x}(t) \cdot e^{j\omega_0 t}\} \qquad \text{Glg. 4}$$

Fig. 5B zeigt eine Vorverzerrungseinrichtung 504 zum Vorverzerren eines I/Q-Signals bzw. einer I-Komponente und einer Q-Komponente eines I/Q-Signals. Komplex dargestellt wird dabei das I/Q-Signal mit einem Vorverzerrungssignal

$$\underline{p}(t) = p_1(t) + jp_2(t) = \rho(t) \cdot e^{j\phi(t)} \qquad \text{Glg. 5}$$

durch Multiplikation vorverzerrt, um ein vorverzerrtes I/Q-Signal zu erhalten.

$$\underline{x}_p(t) = \underline{x}(t) \cdot \underline{p}(t) = i_p(t) + jq_p(t) \qquad \text{Glg. 6}$$

$$i_p(t) = i(t) \cdot p_1(t) - q(t) \cdot p_2(t) \qquad \text{Glg. 7}$$

$$q_p(t) = i(t) \cdot p_2(t) + q(t) \cdot p_1(t) \qquad \text{Glg. 8}$$

Die Vorverzerrungseinrichtung 504 weist einen ersten Multiplizierer 514, einen zweiten Multiplizierer 516, einen dritten Multiplizierer 518, einen vierten Multiplizierer 520, einen ersten Addierer 522, einen zweiten Addierer 524 und eine Einrichtung 526 zum Erzeugen eines Vorverzerrungssignals auf.

Der erste Multiplizierer 514 weist einen ersten Eingang, der mit einem ersten Eingang der Vorverzerrungseinrichtung 504 verbunden ist, an dem die I-Komponente des I/Q-Signals angelegt ist, und einen zweiten Eingang, der mit einem ersten Ausgang der Einrichtung 526 zum Erzeugen eines Vorverzerrungssignals $p(t)$ verbunden ist, an dem die erste Vorverzerrungskomponente $p_1(t)$ des Vorverzerrungssignals nach Gleichung 5 anliegt, und einen Ausgang auf, der mit einem ersten Eingang des ersten Addierers 522 verbunden ist.

Der zweite Multiplizierer 516 weist einen ersten Eingang, der mit einem zweiten Eingang der Vorverzerrungseinrichtung 504 verbunden ist, an dem die Q-Komponente des I/Q-Signals angelegt ist, einen zweiten Eingang, der mit einem zweiten Ausgang der Einrichtung 526 zum Erzeugen eines Vorverzerrungssignals verbunden ist, an dem die zweite Vorverzerrungskomponente $p_2(t)$ des Vorverzerrungssignals $p(t)$ anliegt, und einen Ausgang auf, der mit einem invertierenden zweiten Eingang des ersten Addierers 522 verbunden ist.

Der dritte Multiplizierer 518 weist einen ersten Eingang, der mit dem zweiten Eingang der Vorverzerrungseinrichtung 504 verbunden ist, an dem die Q-Komponente des I/Q-Signals anliegt, einen zweiten Eingang, der mit dem ersten Ausgang der Einrichtung 526 zum Erzeugen eines Vorverzerrungssignals verbunden ist, und einen Ausgang auf, der mit einem ersten Eingang des zweiten Addierers 524 verbunden ist.

Der vierte Multiplizierer 520 weist einen Eingang auf, der mit dem ersten Eingang der Vorverzerrungseinrichtung 504 verbunden ist, an den die I-Komponente des I/Q-Signals anliegt, einen zweiten Eingang, der mit dem zweiten Ausgang der Einrichtung 526 zum Erzeugen eines Vorverzerrungssignals verbunden ist, und einen Ausgang auf, der mit einem zweiten Eingang des zweiten Addierers 524 verbunden ist.

Ein Ausgang des ersten Addierers ist ein erster Ausgang der Vorverzerrungseinrichtung 504 und ein Ausgang des zweiten Addierers ist ein zweiter Ausgang der Vorverzerrungseinrichtung 504.

Die Einrichtung 526 zum Erzeugen des Vorverzerrungssignals liefert an dem ersten Ausgang die erste Kom-ponente $p_1(t)$ des Vorverzerrungssignals $p(t)$ und an dem zweiten Ausgang die zweite Komponente $p_2(t)$ des Vorver-zerrungssignals $p(t)$ abhängig von der an einem ersten Eingang der Einrichtung 526 zum Erzeugen eines Vorver-rungssignals anliegenden I-Komponente $i(t)$ des I/Q-Signals und von der an einem zweiten Eingang anliegenden Q-Komponente $q(t)$ des I/Q-Signals.

Im folgenden ist kurz die Funktionsweise der Vorverzerrungseinrichtung 504 in Fig. 5B beschrieben. Die Funktion des ersten Addierers 522 besteht darin, die in Gleichung 7 angegebene Differenz zu bilden, wobei der erste Multiplizierer 514 die erste in Gleichung 7 auftretende Multiplikation und der zweite Multiplizierer 516 die zweite in Gleichung 7 auftretende Multiplikation ausführt. Die Funktion des zweiten Addierers 524 besteht darin, die in Gleichung 8 angegebene Summe zu bilden, wobei der dritte Multiplizierer 518 die zweite in Gleichung 8 auftretende Multiplikation und der vierte Multiplizierer 520 die erste in Gleichung 8 auftretende Multiplikation ausführt.

Fig. 5C zeigt den Gesamtaufbau des herkömmlichen I/Q-Modulators 500 mit Vorverzerrung des I/Q-Signals, der die Einrichtung 502 zum Aufbringen eines I/Q-Signals auf einem Trägersignal nach Fig. 5A und die Vorverzerrungseinrichtung 504 nach Fig. 5B aufweist.

Der herkömmliche I/Q-Modulator 500 nach Fig. 5C liefert jetzt an seinem Ausgang, d. h. als Ergebnis der Addition des Addierers 512, folgendes Ausgangsignal:

$$y(t) = \mathrm{Re}\{\underline{x}(t) \cdot \underline{p}(t) \cdot e^{j\omega_0 t}\} \qquad \text{Glg. 9}$$

$$y(t) = \mathrm{Re}\{\underline{x}_p(t) \cdot e^{j\omega_0 t}\} = i_p(t) \cdot \cos\omega_0 t - q_p(t) \cdot \sin\omega_0 t \qquad \text{Glg. 10}$$

Dies ist das vorverzerrte auf ein Trägersignal modulierte I/Q-Signal.

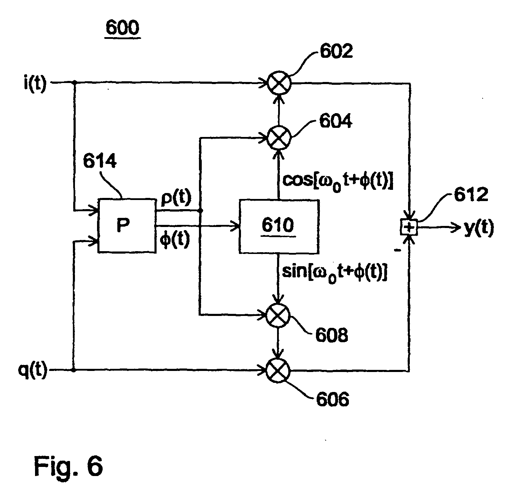

Fig. 6 zeigt einen I/Q-Modulator 600 mit Vorverzerrung des Trägersignals. Im Gegensatz zu dem I/Q-Modulator von Fig. 5A, B, C wird nun anstatt dem I/Q-Signal das Trägersignal durch ein Vorverzerrungssignal $\underline{p}(t)$ vorverzerrt, um eine vorverzerrtes Trägersignal zu erhalten.

$$\underline{t}_{\underline{p}}(t) = \underline{p}(t) \cdot e^{j\omega_0 t} = \rho(t) \cdot e^{j[\omega_0 t + \phi(t)]} \qquad \text{Glg. 11}$$

Für einen I/Q-Modulator mit Vorverzerrung des Trägersignals erhält man mit Gleichung 9 und Gleichung 11 das Ausgangssignal dieses I/Q-Modulators.

$$y(t) = \text{Re}\{\underline{x}(t) \cdot \underline{t}_{\underline{p}}(t)\} \qquad \text{Glg. 12}$$

$= i(t) \cdot \rho(t) \cdot \cos[\omega_0 t + \phi(t)] - q(t) \cdot \rho(t) \cdot \sin[\omega_0 t + \phi(t)]$

Der I/Q-Modulator 600 in Fig. 6 weist einen ersten Multiplizierer 602, einen zweiten Multiplizierer 604, einen dritten Multiplizierer 606, einen vierten Multiplizierer 608, eine Einrichtung 610 zum Erzeugen eines Trägersignals, einen Addierer 612 und eine Einrichtung 614 zum Erzeugen eines Verzerrungssignals auf.

Der erste Multiplizierer 602 weist einen ersten Eingang, der mit einem ersten Eingang des I/Q-Modulators 600 verbunden ist, an dem die I-Komponente i(t) des I/Q-Signals angelegt ist, einen zweiten Eingang, der mit einem Ausgang des zweiten Multiplizierers 604 verbunden ist, und einen Ausgang auf, der mit einem ersten Eingang des Addierers 612 verbunden ist.

Der zweite Multiplizierer 604 weist einen ersten Eingang, der mit einem ersten Ausgang der Einrichtung 614 zum Erzeugen eines Vorverzerrungssignals verbunden ist, an dem der Betrag rho(t) des Vorverzerrungssignals $\underline{p}(t)$ anliegt, und einen zweiten Eingang, der mit einem ersten Ausgang der Einrichtung 610 zum Erzeugen eines Trägersignals verbunden ist, an dem eine erste Teilkomponente des Trägersignals, hier eine Cosinus-Funktion, angelegt ist, und den Ausgang auf, der mit dem zweiten Eingang des ersten Multiplizierers 602 verbunden ist.

Der dritte Multiplizierer 606 weist einen Eingang, der mit einem zweiten Eingang des I/Q-Modulators 600 verbunden ist, an dem die Q-Komponente q(t) des I/Q-Signals anliegt, einen zweiten Eingang, der mit einem Ausgang des vierten Multiplizierers 608 verbunden ist, und einen Ausgang auf, der mit einem invertierenden zweiten Eingang des Addierers 612 verbunden ist.

Der vierte Multiplizierer 608 weist einen ersten Eingang, der mit einem ersten Ausgang der Einrichtung 614 zum Erzeugen eines Vorverzerrungssignals, an dem der Betrag rho (t) des polaren Vorverzerrungssignals $\underline{p}(t)$ anliegt, verbunden ist, einen zweiten Eingang, der mit einem zweiten Ausgang der Einrichtung 610 zum Erzeugen eines Trägersignals, an dem eine zweite Teilkomponente des Trägesignals, hier die Sinus-Funktion, anliegt, verbunden ist, und den Ausgang auf, der mit dem zweiten Eingang des dritten Multiplizierers 606 verbunden ist.

Die Einrichtung 620 zum Erzeugen eines Trägersignals weist den erwähnten ersten und den erwähnten zweiten Ausgang auf, an denen die erste bzw. die zweite Teilkomponente des Trägersignals, hier die Cosinus- bzw. die Sinus-Komponente, anliegen, und einen Eingang auf, der mit einem zweiten Ausgang der Einrichtung 614 zum Erzeugen eines Vorverzerrungssignals verbunden ist, an dem die Phase $\phi(t)$ des polaren Vorverzerrungssignals anliegt.

Die Einrichtung 614 zum Erzeugen eines Vorverzerrungssignals liefert mindestens abhängig von der I-Komponente i(t) des I/Q-Signals an einem ersten Eingang der Einrichtung 614 zum Erzeugen eines Vorverzerrungssignals, der mit dem ersten Eingang des I/Q-Modulators 600 verbunden ist, und der Q-Komponente q(t) des I/Q-Signals an einem zweiten Eingang der Einrichtung 614 zum Erzeugen eines Vorverzerrungssignals, der mit dem zweiten Eingang des I/Q-Modulators 600 verbunden ist, an dem ersten Ausgang derselben den Betrag rho(t) des Vorverzerrungssignals $\underline{p}(t)$ und an dem zweiten Ausgang derselben die Phase $\phi(t)$ des Vorverzerrungssignals $\underline{p}(t)$.

Die Funktionsweise des I/Q-Modulators 600 mit Vorverzerrung des Trägersignals gemäß Fig. 6 ist im folgenden kurz beschrieben. Die Funktion des Addierers 612 besteht darin, die Differenz in Gleichung 12 zu bilden. Der erste Summand von Gleichung 12 wird dabei durch den ersten Multiplizierer 602 und den zweiten Multiplizierer 604 und der zweite Summand von Gleichung 12 wird durch den dritten Multiplizierer 606 und den vierten Multiplizierer 608 erzeugt.

Der zweite Multiplizierer 604 bildet die zweite Multiplikation des ersten Summanden von Gleichung 12, d. h. die Multiplikation der ersten Teilkomponente des Trägersignals mit dem Betrag des Vorverzerrungssignals, um eine vorverzerrte erste Teilkomponente des Trägersignals zu erzeugen, während der erste Multiplizierer 602 die erste Multiplikation des Summanden von Gleichung 12 bildet, d. h. die Multiplikation der vorverzerrten ersten Teilkomponente des Trägersignals mit der I-Komponente des I/Q-Signals.

Der vierte Multiplizierer 608 bildet die zweite Multiplikation des zweiten Summanden von Gleichung 12, d. h. die Multiplikation der zweiten Teilkomponente des Trägersignals mit dem Betrag des Vorverzerrungssignals, um eine vorverzerrte zweite Teilkomponente des Trägersignals zu erhalten, und der dritte Multiplizierer 606 bildet die erste Multiplikation des zweiten Summanden in Gleichung 12, d. h. die Multiplikation der vorverzerrten zweiten Teilkomponente des Trägersignals mit der Q-Komponente des I/Q-Signals.

Ein Nachteil des herkömmlichen I/Q-Modulators 500 mit Vorverzerrung des I/Q-Signals nach Fig. 5A, B, C und des I/Q-Modulators 600 mit Vorverzerrung des Trägersignals nach Fig. 6 besteht darin, daß sechs bzw. vier Multiplizierer benötigt werden, um die I/Q-Modulatoren schaltungstechnisch zu realisieren. Bei modernen Sendeeinrichtungen werden die Vorverzerrung und die I/Q-Modulationen digital bzw. zeitdiskret durchgeführt. Aufgrund der hohen Bandbreite und der hohen Genauigkeitsanforderungen neuerer Übertragungsverfahren, wie z. B. W-CDMA (CDMA = Code-Division Multiple Access = Codemultiplex-Vielfachzugriff), werden dazu aufwendige schnelle digitale Multiplizierer mit hoher Auflösung von typischerweise 14 Bit benötigt.

Ein weiterer Nachteil besteht darin, daß die Gatteranzahl und die Leistungsaufnahme der herkömmlichen I/Q-Modulatoren nach Fig. 5A, 5B, 5C und nach Fig. 6 bedingt durch die hohe Zahl der Multiplizierer sehr hoch sind.

Die Aufgabe der vorliegenden Erfindung besteht darin, einen vereinfachten I/Q-Modulator zum Verarbeiten eines zeitdiskreten I/Q-Signals und ein vereinfachtes Verfahren zum Verarbeiten eines zeitdiskreten I/Q-Signals zu schaffen.

Diese Aufgabe wird durch einen I/Q-Modulator zum Verarbeiten eines zeitdiskreten I/Q-Signals gemäß Anspruch 1 oder 5 und ein Verfahren zum Verarbeiten eines zeitdiskreten I/Q-Signals gemäß Anspruch 12 oder 13 gelöst.

Der Erfindung liegt die Erkenntnis zugrunde, daß durch die Wahl eines bestimmtes Abtastverhältnisses der digitalen Signale bei der zeitdiskreten bzw. digitalen Realisierung eines I/Q-Modulators aufgrund der Symmetrieeigenschaften der orthogonalen Teilkomponenten des Trägersignals, auf das das I/Q-Signal aufgebracht wird, eine wesentliche Strukturvereinfachung des digitalen I/Q-Modulators erreicht werden kann.

Bevorzugte Ausführungsbeispiele der vorliegenden Erfindung werden nachfolgend unter Bezugnahme auf die beigefügten zeichnungen näher erläutert. Es zeigen:

Fig. 1A und B die Komponenten und Fig. 1C den Gesamtaufbau eines ersten Ausführungsbeispiels eines digitalen I/Q-Modulators mit Vorverzerrung des I/Q-Signals gemäß der Erfindung;

Fig. 2 ein zweites Ausführungsbeispiel eines digitalen I/Q-Modulators mit Vorverzerrung des Trägersignals gemäß der Erfindung;

Fig. 3 ein drittes Ausführungsbeispiel eines digitalen I/Q-Modulators mit Vorverzerrung des Trägersignals gemäß der Erfindung;

Fig. 4 eine herkömmliche Sendeeinrichtung mit einem I/Q-Modulator mit Vorverzerrung;

Fig. 5A, B die Komponenten und Fig. 5C den Gesamtaufbau eines herkömmlichen I/Q-Modulators mit Vorverzerrung des I/Q-Signals; und

Fig. 6 einen I/Q-Modulator mit Vorverzerrung des Trägersignals.

Bei einer digitalen Realisierung eines I/Q-Modulators werden alle Signale durch Abtastwerte im Abstand $T_A$ = $l/f_A$ dargestellt, wobei $f_A$ die Abtastrate ist und die Zeit $t = nT_A$ und die Phase $\Omega_0 = omega_0 T_A$ sind. $n$ ist der zeitliche Index.

Ein I/Q-Modulator mit Vorverzerrung des I/Q-Signals nach Fig. 5A, B, C wird im zeitdiskreten Fall dann durch die folgenden Gleichungen beschrieben

$$i_p(n) = i(n) \cdot p_1(n) - q(n) \cdot p_2(n) \qquad \text{Glg. 13}$$

$$q_p(n) = i(n) \cdot p_2(n) + q(n) \cdot p_1(n) \qquad \text{Glg. 14}$$

$$y(n) = i_p(n) \cdot \cos\Omega_0 n - q_p(n) \cdot sin\Omega_0 n \qquad \text{Glg. 15}$$

Diese Gleichungen folgen unter Verwendung von zeitdiskreten Signalen aus den Gleichungen 7, 8 und 10 für den I/Q-Modulator mit Vorverzerrung des I/Q-Signals.

Ein I/Q-Modulator mit Vorverzerrung des Trägersignals nach Fig. 6 wird hingegen zeitdiskret durch die folgende Gleichung beschrieben

$$y(n) = i(n) \cdot \rho(n) \cdot cos[\Omega_0 n + \phi(n)] - q(n) \cdot \rho(n) \cdot sin[\Omega_0 n + \phi(n)] \qquad \text{Glg. 16}$$

Diese Gleichung folgt unter Verwendung von zeitdiskreten Signalen aus der Gleichung 12 für einen I/Q-Modulator mit Vorverzerrung des Trägersignals.

Da man hier die orthogonalen Funktionen Cosinus und Sinus für die Teilkomponenten des Trägersignals verwendet, können die Symmetrieeigenschaften bzw. die periodischen Eigenschaften dieser Funktionen für die digitale Realisierung der I/Q-Modulatoren genutzt werden. Wählt man als Abtastrate $f_A$ die vierfache Trägerfrequenz $f_0$, so erhält man:

$$\Omega_0 = \omega_0 T_A = \frac{2\pi f_0}{f_A} \overset{f_A = 4f_0}{=} \cdot \frac{\pi}{2} \qquad\qquad \text{Glg. 17}$$

und als Folge daraus

$$\cos\Omega_0 n = ..., 1,0,-1,0,... \qquad \text{für } n = ...,0,1,2,3,... \qquad\qquad \text{Glg. 18}$$

$$\sin\Omega_0 n = ..., 0,1,0,-1,... \qquad \text{für } n = ...,0,1,2,3,... \qquad\qquad \text{Glg. 19}$$

Berücksichtigt man diese Wahl der Abtastfrequenz $f_A$ in der Gleichung 15 für das Ausgangssignals eines I/Q-Modulators 500 mit Vorverzerrung des I/Q-Signals nach Fig. 5C, so erhält man für das Ausgangssignal bei dieser Abtastrate:

$$\begin{aligned}
y(n) \;&=\; \ldots, i_p(0), -q_p(1), -i_p(2), q_p(3), \ldots \\
&=\; \begin{cases} (-1)^{\frac{n}{2}}\, i_p(n) & n \text{ gerade} \\ (-1)^{\frac{n+1}{2}}\, q_p(n) & n \text{ ungerade} \end{cases} \qquad\qquad \text{Glg. 20.}
\end{aligned}$$

Man erkennt, daß die I-Komponente und die Q-Komponente des vorverzerrten I/Q-Signals nach Gleichung 6 nur alternierend benötigt werden. Deshalb können die vier Multiplizierer der Vorverzerrungseinrichtung 504 von Fig. 5B durch zwei Multiplizierer und zwei Multiplexer ersetzt werden, und die beiden Ausgänge der Vorverzerrungseinrichtung 504 können zu einem Ausgang zusammengefaßt werden. An diesem Ausgang einer sich ergebenden Vorverzerrungseinrichtung erhält man:

$$\begin{aligned}
v(n) \;&=\; \ldots, i_p(0), q_p(1), i_p(2), q_p(3), \ldots \qquad \text{für } n = \ldots, 0, 1, 2, 3, \ldots \\
&=\; \begin{cases} i_p(n) & n \text{ gerade} \\ q_p(n) & n \text{ ungerade} \end{cases} \qquad\qquad\qquad\qquad \text{Glg. 21.}
\end{aligned}$$

Die Einrichtung 502 zum Aufbringen eines I/Q-Signals auf einem Trägersignal nach Fig. 5A geht, wie man aus einem Vergleich der Gleichung 20 und der Gleichung 21 erkennt, in eine Einrichtung zum Einstellen der Vorzeichen über.

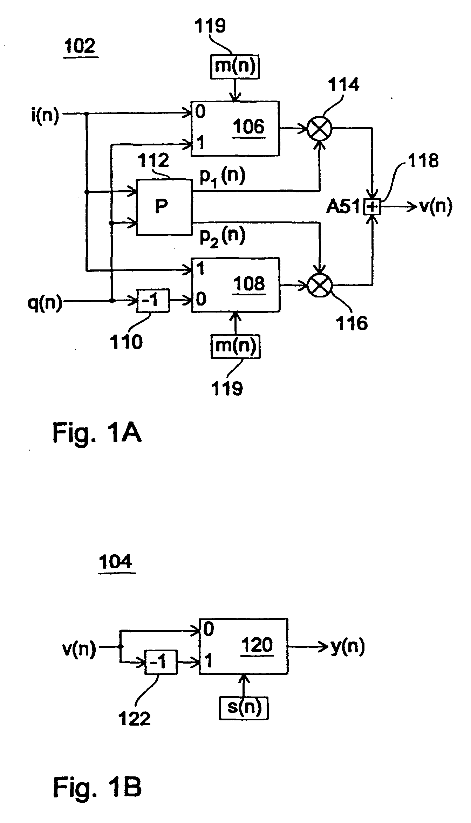

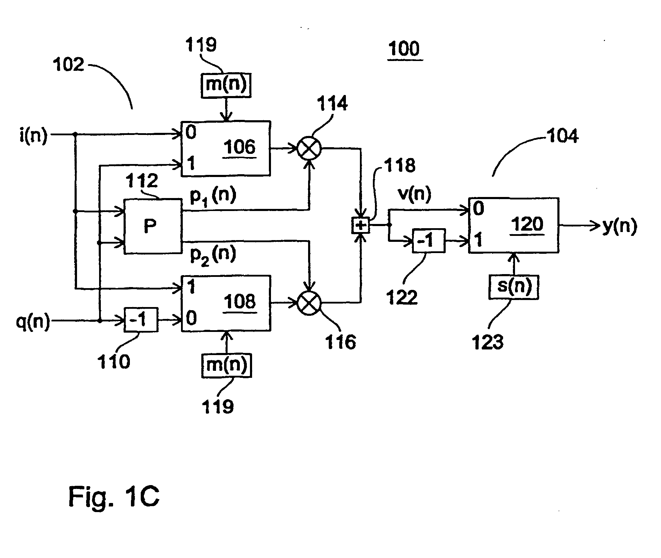

Fig. 1A und B zeigen die Komponenten und Fig. 1C zeigt den Gesamtaufbau eines ersten Ausführungsbeispiels eines aus diesen Überlegungen folgenden I/Q-Modulators 100 mit Vorverzerrung des I/Q-Signals, der eine Vorverzerrungseinrichtung 102 nach Fig. 1A und eine Einrichtung 104 zum Einstellen der Vorzeichen nach Fig. 1B aufweist.

Fig. 1A zeigt die Vorverzerrungseinrichtung 102 des I/Q-Modulators mit Vorverzerrung des I/Q-Signals gemäß der Erfindung. Die Vorverzerrungseinrichtung 102 weist einen ersten Multiplexer 106, einen zweiten Multiplexer 108, einen Invertierer 110, eine Einrichtung 112 zum Erzeugen eines Vorverzerrungssignals, einen ersten Multiplizierer 114, einen zweiten Multiplizierer 116, einen Addierer 118 und eine Steuereinrichtung 119 auf.

Der erste Multiplexer 106 weist einen ersten Eingang, der mit einem ersten Eingang der Vorverzerrungseinrichtung 102, an dem die I-Komponente des I/Q-Signals anliegt, verbunden ist, einen zweiten Eingang, der mit einem zweiten Eingang der Vorverzerrungseinrichtung 102, an dem die Q-Komponente des I/Q-Signals anliegt, verbunden ist, und einen Ausgang auf, der mit einem ersten Eingang des ersten Multiplizierers 114 verbunden ist.

Der zweite Multiplexer 108 weist einen ersten Eingang, der mit dem ersten Eingang der Vorverzerrungseinrichtung 102 verbunden ist, einen zweiten Eingang, der mit einem Ausgang des Invertierers 110 verbunden ist, und einen Ausgang auf, der mit einem ersten Eingang des zweiten Multiplizierers 116 verbunden ist. Der Invertierer 110 weist ferner einen Eingang auf, der mit dem zweiten Eingang der Vorverzerrungseinrichtung 102 verbunden ist.

Die Einrichtung 112 zum Erzeugen eines Vorverzerrungssignals weist einen ersten Eingang, der mit dem ersten Eingang der Vorverzerrungseinrichtung 102 verbunden ist, einen zweiten Eingang, der mit dem zweiten Eingang der Vorverzerrungseinrichtung 102 verbunden ist, einen ersten Ausgang, der mit einem zweiten Eingang des ersten Multiplizierers 114 verbunden ist, und einen zweiten Ausgang auf, der mit einem zweiten Eingang des zweiten Multiplizierers 116 verbunden ist.

Der erste Multiplizierer 114 weist ferner einen Ausgang auf, der mit einem ersten Eingang des Addierers 118 verbunden ist, und der zweite Multiplizierer 116 weist ferner einen Ausgang auf, der mit einem zweiten Eingang des Addierers 118 verbunden ist. Der Addierer 118 weist einen Ausgang auf, der der Ausgang der Vorverzerrungseinrichtung 102 ist, an dem das Ausgangssignal anliegt.

Im folgenden ist kurz die Funktionsweise der Vorverzerrungseinrichtung 102 von Fig. 1A beschrieben. Der Addierer 118 erzeugt alternierend gemäß Gleichung 21 am Ausgang der Vorverzerrungseinrichtung 102 entweder die I-Komponente $i_p$ oder die Q-Komponente $q_p$ des vorverzerrten I/Q-Signals nach Gleichung 6. Dabei führt derselbe wechselnd die Subtraktion von Gleichung 13 oder die Addition von Gleichung 14 aus, wobei zur Subtraktion der Gleichung 13 der Invertierer 110 in den Signalweg für den zweiten Summanden von Gleichung 13 geschaltet wird.

Der erste Multiplexer 106, der erste Multiplizierer 114 und die Einrichtung 112 zum Erzeugen eines Vorverzerrungssignals erzeugen alternierend abhängig von dem zeitlichen Index n entweder den ersten Summanden von Gleichung 13 oder den zweiten Summanden von Gleichung 14, die jeweils die erste Vorverzerrungskomponente $p_1$(n) des Vorverzerrungssignals p(n) enthalten, d. h. in Gleichung 13 die Vorverzerrung der I-Komponente i(n) des I/Q-Signals durch die erste Vorverzerrungskomponente $p_1$(n) des Vorverzerrungssignals und in Gleichung 14 die Vorverzerrung der Q-Komponente q(n) des I/Q-Signals durch die erste Vorverzerrungskomponente $p_1$(n) des Vorverzerrungssignals. Die Multiplikation der ersten Vorverzerrungskomponente $p_1$(n) des Vorverzerrungssignals mit entweder der I-Komponente oder der Q-Komponente wird dabei durch den ersten Multiplizierer 114 ausgeführt. Die Auswahl von entweder der I-Komponente oder der Q-Komponente für die Multiplikation des ersten Multiplizierers 114 wird durch den ersten Multiplexer 106 durchgeführt, der durch eine Steuerfunktion m(n) der Steuereinrichtung 119 abhängig von dem zeitlichen Index n gesteuert wird. Der erste Multiplexer 106 wählt abhängig von der Steuerfunktion m(n) jenen seiner Eingänge aus, der durch das Ergebnis der Steuerfunktion adressiert wird, d. h. derselbe wählt abhängig von der Steuerfunktion entweder die I-Komponente am "0"-Eingang, dem ersten Eingang des ersten Multiplexers 106, der für das Ergebnis Null der Steuerfunktion ausgewählt wird, oder die Q-Komponente am "1"-Eingang, der zweite Eingang des ersten Multiplexers 106, der für das Ergebnis Eins der Steuerfunktion ausgewählt wird, aus.

Der zweite Multiplexer 108, der zweite Multiplizierer 116, der Invertierer 110 und die Einrichtung 112 zum Erzeugen eines Vorverzerrungssignals erzeugen ebenfalls alternierend abhängig vom zeitlichen Index n entweder den zweiten Summanden von Gleichung 13 oder den ersten Summanden von Gleichung 14, die jeweils die zweite Vorverzerrungskomponente $p_2$(n) des Vorverzerrungssignals p(n) enthalten, d. h. in Gleichung 13 die Vorverzerrung der Q-Komponente und in Gleichung 14 die Vorverzerrung der I-Komponente des I/Q-Signals durch die zweite Vorverzerrungskomponente $p_2$(n) des Vorverzerrungssignals. Die Multiplikation der zweiten Vorverzerrungskomponente $p_2$(n) des Vorverzerrungssignals mit entweder der I-oder der Q-Komponente wird dabei durch den zweiten Multiplizierer 116 durchgeführt. Die Auswahl von entweder der Q-Komponente oder der I-Komponente des I/Q-Signals für die Multiplikation des zweiten Multiplizierers 116 wird durch den zweiten Multiplexer 108 durchgeführt, der synchron zu dem ersten Multiplexer 106 ebenfalls durch die Steuerfunktion m(n) der Steuereinrichtung 119 gesteuert wird. Der zweite Multiplexer 108 wählt abhängig von der Steuerfunktion m(n) der Steuereinrichtung 119 jenen seiner Eingänge aus, der durch das Ergebnis der Steuerfunktion adressiert wird, d. h. entweder die I-Komponente des I/Q-Signals am "1"-Eingang bzw. dem ersten Eingang des zweiten Multiplexers 108, wenn die Steuerfunktion m(n) Eins als Ergebnis liefert, oder die invertierte Q-Komponente des I/Q-Signals am "0"-Eingang bzw. zweiten Eingang des zweiten Multiplexers 108, wenn die Steuerfunktion m(n) Null als Ergebnis liefert. Der Invertierer 110 vor dem "0"-Eingang des zweiten Multiplexers 108 sorgt für das negative Vorzeichen der im Addierer 118 alternierend stattfindenden Subtraktion von Gleichung 13. Die Steuerfunktion m(n) der Steuereinrichtung 119 zum Steuern des ersten Multiplexers 106 und des zweiten Multiplexers 108 ist durch die folgende Gleichung gegeben:

$$m(n) = n \bmod 2 = ...,0,1,0,1,... \qquad \text{für } n = ..., 0,1,2,3, ... \qquad \text{Glg. 22}$$

n mod 2 ist der Rest der ganzzahligen Division (div) von n geteilt durch 2 (n div 2).

Schließlich sei bemerkt, daß die Einrichtung 112 zum Erzeugen eines Vorverzerrungssignals p(n) bzw. der ersten Vorverzerrungskomponente $p_1(n)$ und der zweiten Vorverzerrungskomponente $p_2(n)$ jeweils das Vorverzerrungssignal abhängig von der I- und der Q-Komponente des Vorverzerrungssignals einstellt.

Fig. 1B zeigt die Einrichtung 104 zum Einstellen der Vorzeichen des ersten Ausführungsbeispiels eines I/Q-Modulators mit Vorverzerrung des I/Q-Signals gemäß der Erfindung. Wie oben erwähnt, geht die Einrichtung 502 zum Aufbringen eines I/Q-Signals auf einem Trägersignal nach Fig. 5A in eine Einrichtung zum Einstellen der Vorzeichen über, um aus dem Ausgangsignal v(n) nach Gleichung 21 der Vorverzerrungseinrichtung 102 von Fig. 1A das Ausgangssingal y(n) gemäß Gleichung 20 des I/Q-Modulators 100 mit Vorverzerrung des I/Q-Signals nach Fig. 1C zu erhalten.

Die Einrichtung 104 zum Einstellen der Vorzeichen weist einen Multiplexer 120 mit einem ersten und einem zweiten Eingang und einem Ausgang, und einen Invertierer 122 mit einem Eingang und einem Ausgang auf.

Der erste Eingang des Multiplexers 120 ist direkt mit einem Eingang der Einrichtung 104 zum Einstellen der Vorzeichen verbunden, während der zweite Eingang des Multiplexers 120 mit dem Ausgang des Invertierers 122 verbunden ist. Der Ausgang des Multiplexers 120 ist ein Ausgang der Einrichtung 104 zum Einstellen der Vorzeichen. Der Invertierer 122 ist ebenfalls mit seinem Eingang mit dem Eingang der Einrichtung 104 zum Einstellen der Vorzeichen verbunden.

Im folgenden ist kurz die Funktion der Einrichtung 104 zum Einstellen der Vorzeichen beschrieben. Der Multiplexer 120 wählt abhängig von dem Ergebnis einer Steuerfunktion s(n) einer Steuereinrichtung 123 entweder den ersten Eingang bzw. den "0"-Eingang, der dem Ergebnis Null der Steuerfunktion s(n) zugeordnet ist, oder den zweiten Eingang bzw. den "1"-Eingang desselben, der dem Ergebnis Eins der Steuerfunktion s(n) zugeordnet ist, aus. Abhängig davon wird das Ausgangssignal v(n) der Vorverzerrungseinrichtung 102 entweder invertiert, d. h. das Vorzeichen wird umgedreht, oder unverändert auf den Ausgang der Einrichtung 104 zum Einstellen des Vorzeichens gelegt, um das Ausgangssignal des I/Q-Modulators 100 zu liefern.

Die Steuerfunktion s(n) der Steuereinrichtung 123, die den Multiplexer 120 steuert, läßt sich aus dem Vergleich der Gleichungen 20 und 21 ableiten, wobei die Steuerfunktion s(n) die Gleichung 21 auf die Gleichung 20 abbilden muß.

$$s(n) = [(n + 1) \text{ div } 2] \bmod 2 = ..., 0,1,1,0, .. \qquad \text{für } n = ... , 0,1,2,3, .. \qquad \text{Glg. 23}$$

Die Funktion div ist darin eine ganzzahlige Division ohne Rest, während die Funktion mod der Rest einer ganzzahligen Division div ist.

In Fig. 1C ist schließlich der Gesamtaufbau des I/Q-Modulators 100 gezeigt, der die Vorverzerrungseinrichtung 102 nach Fig. 1A und die Einrichtung 104 zum Einstellen der Vorzeichen nach Fig. 1B aufweist.

Der Vorteil des I/Q-Modulators 100 nach Fig. 1C besteht darin, daß derselbe lediglich zwei Multiplizierer anstatt sechs Multiplizierern, wie in Fig. 5C für den herkömmlichen I/Q-Modulator mit Vorverzerrung des I/Q-Signals gezeigt, benötigt, und damit sowohl die Gatteranzahl als auch die Leistungsaufnahme reduziert werden.

Berücksichtigt man nun die Wahl der Abtastfrequenz nach Gleichung 17 und die daraus entstehenden Folgen nach Gleichung 18 und 19 in der Gleichung 16 für das Ausgangssignal eines I/Q-Modulators mit Vorverzerrung des Trägersignals und in der Gleichung 11 für das vorverzerrte Trägersignal, dann erhält man

$$t_1(n) = \rho(n) \cdot \cos[\Omega_0 n + \phi(n)] = ..., p_1(0), -p_2(1), -p_1(2), p_2(3),... \qquad \text{Glg. 24}$$

$$t_2(n) = \rho(n) \cdot \sin[\Omega_0 n + \phi(n)] = ..., p_2(0), p_1(1), -p_2(2), -p_1(3),... \qquad \text{Glg. 25}$$

$$y(n) = i(n) \cdot t_1(n) - q(n) \cdot t_2(n) \qquad \text{Glg. 26}$$

Darin sind

$$p_1(n) = \rho(n) \cdot \cos\phi(n) \, , \, p_2(n) = \rho(n) \cdot \sin\phi(n) \qquad \text{Glg. 27}$$

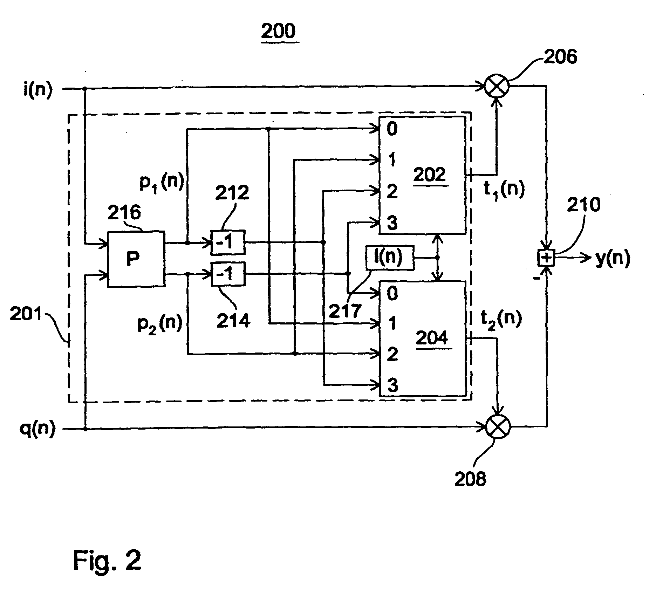

Fig. 2 zeigt ein zweites Ausführungsbeispiel eines aus diesen Überlegungen folgenden I/Q-Modulators 200 mit Vorverzerrung des Trägersignals. Der I/Q-Modulator 200 weist einen ersten Multiplexer 202, einen zweiten Multiplexer 204, einen ersten Multiplizierer 206, einen zweiten Multiplizierer 208, einen Addierer 210, einen ersten Invertierer 212, einen zweiten Invertierer 214, eine Einrichtung 216 zum Erzeugen eines Vorverzerrungssignals und eine Steuereinrichtung 217 auf. Der erste Multiplexer 202, der zweite Multiplexer 204, der erste Invertierer 212, der zweite Invertierer 214, die Einrichtung 216 zum Erzeugen eines Vorverzerrungssignals und die Steuereinrichtung 217 bilden dabei eine Vorverzerrungseinrichtung 201 zum Vorverzerren eines Trägersignals.

Der erste Multiplexer 202 weist einen ersten Eingang, der mit einem ersten Ausgang der Einrichtung 216 zum Erzeugen eines Vorverzerrungsignals, an dem eine erste Vorverzerrungskomponente $p_1(n)$ anliegt, verbunden ist, einen zweiten Eingang, der mit einem zweiten Ausgang der Einrichtung 216 zum Erzeugen eines Vorverzerrungssignals, an dem eine zweite Vorverzerrungskomponente $p_2(n)$ anliegt, verbunden ist, einen dritten Ausgang, der mit einem Ausgang des ersten Invertierers 212 verbunden ist, einen vierten Eingang, der mit einem Ausgang des zweiten Invertierers 214 verbunden ist, und einen Ausgang auf, der mit einem ersten Eingang des ersten Multiplizierers 206 verbunden ist.

Der zweite Multiplexer 204 weist einen ersten Eingang, der mit dem Ausgang des zweiten Invertierers 214 verbunden ist, einen zweiten Eingang, der mit dem ersten Ausgang der Einrichtung 216 zum Erzeugen eines Vorverzerrungssignals verbunden ist, einen dritten Eingang, der mit dem zweiten Ausgang der Einrichtung 216 zum Erzeugen eines Vorverzerrungssignals verbunden ist, einen vierten Eingang, der mit dem Ausgang des ersten Invertierers 212 verbunden ist, und einen Ausgang auf, der mit einem ersten Eingang des zweiten Multiplizierers 208 verbunden ist.

Der erste Multiplizierer 206 weist ferner einen zweiten Eingang, der mit einem ersten Eingang des I/Q-Modulators 200, an dem die I-Komponente $i(n)$ des I/Q-Signals anliegt, verbunden ist, und einen Ausgang auf, der mit einem ersten Eingang des Addierers 210 verbunden ist. Der zweite Multiplizierer weist ferner einen zweiten Eingang, der mit einem zweiten Eingang des I/Q-Modulators 200, an dem die Q-Komponente $q(n)$ des I/Q-Signals anliegt, verbunden ist, und einen Ausgang auf, der mit einem zweiten Eingang des Addierers 210 verbunden ist.

Der Addierer 210 weist neben dem ersten und dem zweiten Eingang ferner einen Ausgang auf, der ein Ausgang des I/Q-Modulators 200 ist, an dem das Ausgangssignal $y(n)$ desselben anliegt. Die Einrichtung 216 zum Erzeugen eines Vorverzerrungssignals weist ferner einen ersten Eingang, der mit dem ersten Eingang des I/Q-Modulators 200 verbunden ist, und einen zweiten Eingang, der mit dem zweiten Eingang des I/Q-Modulators 200 verbunden ist, auf. Ferner ist ein Eingang des ersten Invertierers 212 mit dem ersten Ausgang der Einrichtung 216 zum Erzeugen eines Vorverzerrungssignals verbunden, und ein Eingang des zweiten Invertierers 214 ist mit dem zweiten Ausgang der Einrichtung 216 zum Erzeugen eines Vorverzerrungssignals verbunden.

Im folgenden ist kurz die Funktion des I/Q-Modulators 200 nach Fig. 2 beschrieben. Der Addierer 210 bildet die Differenz der Gleichung 26, um das Ausgangssignal $y(n)$ des I/Q-Modulators 200 zu erzeugen. Der erste Multiplizierer 206 erzeugt dabei das Signal am ersten Eingang des Addierers 210, das durch den ersten Summanden der Gleichung 26 als Produkt der I-Komponente $i(n)$ des I/Q-Signals und der ersten vorverzerrten Teilkomponente $t_1(n)$ des Trägersignals beschrieben ist, während der zweite Multiplizierer 208 das Signal am zweiten Eingang des Addierers 210 erzeugt, das durch den zweiten Summanden der Gleichung 26 als Produkt der Q-Komponente $q(n)$ des I/Q-Signals und der zweiten vorverzerrten Teilkomponente $t_2(n)$ des Trägersignals beschrieben ist.

Der erste Multiplexer 202 erzeugt die erste vorverzerrte Teilkomponente $t_1(n)$ des Trägersignals, die durch die Gleichung 24 beschrieben ist. Wie aus Gleichung 24 sichtbar ist, variiert sowohl die Vorverzerrungskomponente des Vorverzerrungssignals, d. h. es wird entweder die erste $p_1(n)$ oder die zweite Vorverzerrungskomponente $p_2(n)$ ausgewählt, die die erste vorverzerrte Teilkomponente $t_1(n)$ des Trägersignals bestimmt, wie auch das Vorzeichen dieser Vorverzerrungskomponente mit dem zeitlichen Index n. Die Funktion der ersten vorverzerrten Teilkomponente des Trägersignals in Abhängigkeit von n kann mit einem Multiplexer mit vier Eingängen und einem Ausgang, d. h. dem ersten Multiplexer 202 in Fig. 2, realisiert werden, der mit einer Steuerfunktion $l(n)$ der Steuereinrichtung 217 gesteuert wird. Abhängig von dem Ergebnis dieser Steuerfunktion $l(n)$ wird der dem Ergebnis zugeordnete jeweilige Eingang des ersten Multiplexers 202 ausgewählt und auf den Ausgang des ersten Multiplexers 202 gelegt. Ist das Ergebnis der Steuerfunktion Null, so wird der "0"-Eingang, d. h. der erste Eingang des ersten Multiplexers 202, ausgewählt, an dem die Vorverzerrungskomponente $p_1(n)$ angelegt ist. Ist das Ergebnis der Steuerfunktion Eins, so wird der "Eins"-Eingang, d. h. der zweite Eingang des ersten Multiplexers 202, ausgewählt, an dem die zweite Vorverzerrungskomponente $p_2(n)$ anliegt. Ist das Ergebnis der Steuerfunktion Zwei, so wird der "2"-Eingang, d. h. der dritte Eingang des ersten Multiplexers 202, ausgewählt, an dem die durch den ersten Invertierer 212 invertierte erste Vorverzerrungskomponente $-p_1(n)$ anliegt. Ist das Ergebnis der Steuerfunktion Drei, so wird der "3"-Eingang, d. h. der vierte Eingang des ersten Multiplexers 202 ausgewählt, an dem die durch den zweiten Invertierer 214 invertierte zweite Vorverzerrungskomponente $-p_2(n)$ anliegt, ausgewählt. Die Zuordnung der ersten vorverzerrten Teilkomponente $t_1(n)$ des Trägersignals in Gleichung 24 zu der ersten $p_1(n)$ und der zweiten $p_2(n)$ Vorverzerrungskomponente des Vorverzerrungssignals in Abhängigkeit von n ist also durch die Steuerfunktion $l(n)$ beschrieben.

$$l(n) = n \bmod 4 \qquad \text{Glg. 28}$$

Die Funktion mod ist der Rest einer ganzzahligen Division (div).

Der zweite Multiplexer 204 in Fig. 2 erzeugt die zweite vorverzerrte Teilkomponente $t_2(n)$ des Trägersignals, die durch die Gleichung 25 beschrieben ist. Wie aus Gleichung 25 sichtbar ist, variiert sowohl die Vorverzerrungskomponente des Vorverzerrungssignals, d. h. es wird entweder die erste $p_1(n)$ oder die zweite $p_2(n)$ Vorverzerrungskomponente des Vorverzerrungssignals ausgewählt, die die zweite vorverzerrte Teilkomponente des Trägersignals bestimmt, als auch das Vorzeichen dieser Vorverzerrungskomponente mit dem zeitlichen Index n. Die Funktion der zweiten vorverzerrten Teilkomponente $t_2(n)$ des Trägersignals in Abhängigkeit von n kann ebenfalls mit einem Multiplexer mit vier Eingängen und einem Ausgang, d. h. hier dem zweiten Multiplexer 204 in Fig. 2, realisiert werden, der ebenfalls mit der Steuerfunktion l(n) der Steuereinrichtung 217 synchron zu dem ersten Multiplexer 202 gesteuert wird. Abhängig von dem Ergebnis dieser Steuerfunktion l(n) wird der dem Ergebnis zugeordnete jeweilige Eingang des zweiten Multiplexers 204 ausgewählt und auf den Ausgang des zweiten Multiplexers 204 gelegt. Ist das Ergebnis der Steuerfunktion l(n) Null, so wird der "0"-Eingang, d. h. der erste Eingang des zweiten Multiplexers 204, ausgewählt, an dem die durch den zweiten Invertierer 214 invertierte zweite Vorverzerrungskomponente $-p_2(n)$ angelegt ist. Ist das Ergebnis der Steuerfunktion Eins, so wird der "1"-Eingang, d. h. der zweite Eingang des zweiten Multiplexers 204, ausgewählt, an dem die erste Vorverzerrungskomponente $p_1(n)$ anliegt. Ist das Ergebnis der Steuerfunktion Zwei, so wird der "2"-Eingang, d. h. der dritte Eingang des zweiten Multiplexers 204, ausgewählt, an dem die zweite Vorverzerrungskomponente $p_2(n)$ anliegt. Ist das Ergebnis der Steuerfunktion Drei, so wird der "3"-Eingang, der der vierte Eingang des zweiten Multiplexers 204 ist, ausgewählt, an dem die durch den ersten Invertierer 212 invertierte erste Vorverzerrungskomponente $-p_1(n)$ anliegt.

Schließlich sei noch bemerkt, daß die Einrichtung 216 zum Erzeugen eines Vorverzerrungssignals in Fig. 2 das Vorverzerrungssignal p(n), bzw. die erste Vorverzerrungskomponente $p_1(n)$ und die zweite Vorverzerrungskomponente $p_2(n)$, in Abhängigkeit von mindestens der I- und der Q-Komponente i(n), q(n) des I/Q-Signals erzeugt. Die erste Vorverzerrungskomponente $p_1(n)$ liegt dabei an dem ersten Ausgang der Einrichtung 216 zum Erzeugen des Vorverzerrungssignals an, und die zweite Vorverzerrungskomponente $p_2(n)$ liegt an dem zweiten Ausgang der Einrichtung 216 zum Erzeugen des Vorverzerrungssignals an.

Ein Vorteil des digitalen I/Q-Modulators 200 nach Fig. 2 besteht darin, daß derselbe im Vergleich zu dem herkömmlichen I/Q-Modulator mit vorverzerrung des I/Q-Signals nach Fig. 5C lediglich zwei anstatt sechs Multiplizierer benötigt und damit eine geringere Gatteranzahl und Leistungsaufnahme besitzt.

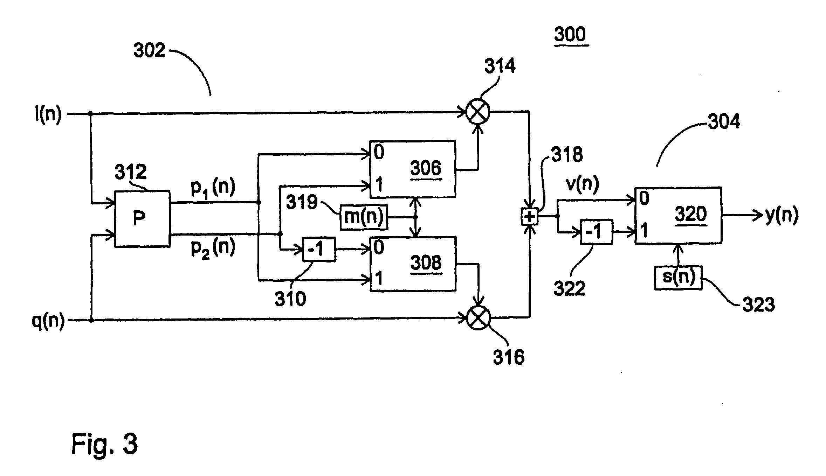

Fig. 3 zeigt ein drittes Ausführungsbeispiel eines digitalen I/Q-Modulators mit Trägervorverzerrung, das aus dem I/Q-Modulator 200 von Fig. 2 abgeleitet werden kann. Der I/Q-Modulator 300 von Fig. 3 weist ähnlich wie der I/Q-Modulator 100 von Fig. 1C bzw. Fig. 1A, B eine Vorverzerrungseinrichtung 302 und eine Einrichtung 304 zum Einstellen der Vorzeichen auf. Die Einrichtung 304 zum Einstellen der Vorzeichen wird hier nicht beschrieben, da dieselbe identisch zu der Einrichtung 104 zum Einstellen der Vorzeichen nach Fig. 1B ist und der Multiplexer 320 derselben ebenfalls die Steuerfunktion s(n) nach Gleichung 23 verwendet. Im folgenden ist jedoch der Aufbau und die Funktion der Vorverzerrungseinrichtung 302 beschrieben.

Die Vorverzerrungseinrichtung 302 des I/Q-Modulators 300 weist einen ersten Multiplexer 306, einen zweiten Multiplexer 308, einen Invertierer 310, eine Einrichtung 312 zum Erzeugen eines Vorverzerrungssignals, einen ersten Multiplizierer 314, einen zweiten Multiplizierer 316, einen Addierer 318 und eine Steuereinrichtung 319 auf.

Der erste Multiplexer 306 weist einen ersten Eingang, der mit einem ersten Ausgang der Einrichtung 312 zum Erzeugen eines Vorverzerrungssignals, an dem die erste Vorverzerrungskomponente $p_1(n)$ des Vorverzerrungssignals anliegt, verbunden ist, einen zweiten Eingang, der mit einem zweiten Ausgang der Einrichtung 312 zum Erzeugen eines Vorverzerrungssignals, an dem die zweite Vorverzerrungskomponente $p_2(n)$ des Vorverzerrungssignals anliegt, verbunden ist, und einen Ausgang auf, der mit einem ersten Eingang des ersten Multiplizierers 314 verbunden ist.

Der zweite Multiplexer 308 weist einen ersten Eingang, der mit einem Ausgang des Invertierers 310 verbunden ist, einen zweiten Eingang, der mit dem ersten Ausgang der Einrichtung 312 zum Erzeugen eines Vorverzerrungssignals verbunden ist, und einen Ausgang auf, der mit einem ersten Eingang des zweiten Multiplizierers 316 verbunden ist.

Der erste Multiplizierer 314 weist ferner einen zweiten Eingang, der mit einem ersten Eingang des I/Q-Modulators 300, an dem die I-Komponente i(n) des I/Q-Signals anliegt, verbunden ist, und einen Ausgang auf, der mit einem ersten Eingang des Addierers 318 verbunden ist. Der zweite Multiplizierer 316 weist ferner einen zweiten Eingang, der mit einem zweiten Eingang des I/Q-Modulators 300, an dem die Q-Komponente q(n) des I/Q-Signals angelegt ist, verbunden ist, und einen Ausgang auf, der mit einem zweiten Eingang des Addierers 318 verbunden ist. Der Addierer 318 weist einen Ausgang auf, der ein Ausgang der Vorverzerrungseinrichtung 302 ist, und erzeugt aus den Signalen am ersten und zweiten Eingang desselben das Ausgangssignal der Vorverzerrungseinrichtung 302.

Die Einrichtung 312 zum Erzeugen eines Vorverzerrungssignals bzw. der ersten Vorverzerrungskomponente $p_1(n)$ und der zweiten Vorverzerrungskomponente $p_2(n)$ weist ferner einen ersten Eingang, der mit dem ersten Eingang des I/Q-Modulators 300, an dem die I-Komponente des I/Q-Signals anliegt, verbunden ist, und einen zweiten Eingang auf, der mit dem zweiten Eingang des I/Q-Modulators, an dem die Q-Komponente des I/Q-Signals anliegt, verbunden ist. Ein Eingang des Invertierers 310 ist schließlich mit dem zweiten Ausgang der Einrichtung 312 zum Erzeugen eines Vorverzerrungssignals verbunden.

Der Addierer 318 führt zu einem Zeitpunkt bzw. zeitlichen Index n die Subtraktion von Gleichung 13 und zu einem anderen folgenden Zeitpunkt die Addition der Gleichung 14 durch, so daß, wie es aus Gleichung 21 hervorgeht, wechselnd entweder die I-Komponente $i_p(n)$ oder die Q-Komponente $q_p(n)$ des vorverzerrten I/Q-Signals nach Gleichung 6 am Ausgang der Vorverzerrungseinrichtung 302 anliegt.

Der erste Multiplizierer 314 führt folglich wechselnd die Multiplikation des ersten Summanden von Gleichung 13, d. h. die Multiplikation der I-Komponente i(n) des I/Q-Signals mit der ersten Vorverzerrungskomponente $p_1(n)$ des Vorverzerrungssignals, und die Multiplikation des ersten Summanden von Gleichung 14, d. h. die Multiplikation der I-Komponente i(n) des I/Q-Signals mit der zweiten Vorverzerrungskomponente $p_2(n)$ des Vorverzerrungssignals, durch.

Der zweite Multiplizierer 316 führt ähnlich wechselnd die Multiplikation des zweiten Summanden von Gleichung 13, d. h. die Multiplikation der Q-Komponente q(n) des I/Q-Signals mit der zweiten Vorverzerrungskomponente $p_2(n)$ des Vorverzerrungssignals, und die Multiplikation des zweiten Summanden von Gleichung 14, d. h. die Multiplikation der Q-Komponente q(n) des I/Q-Signals mit der ersten Vorverzerrungskomponente $p_1(n)$ des Vorverzerrungssignals, durch.

Der erste Multiplexer 306 führt die Auswahl der für den ersten Summanden von Gleichung 13 bzw. Gleichung 14 verwendeten Vorverzerrungskomponente, hier $p_1(n)$ bzw. $p_2(n)$, durch, d. h. bewirkt die oben beschriebene wechselnde Multiplikation des ersten Multiplizierers 314. Abhängig von dem Wert einer Steuerfunktion m(n) der Steuereinrichtung 319 wählt der erste Multiplexer 306 entweder den ersten oder den zweiten Eingang des ersten Multiplexers 306 und damit entweder die erste oder die zweite Vorverzerrungskomponente des Vorverzerrungssignals aus. Ist der Wert der Steuerfunktion m(n) abhängig von n Null, so wird der "0"-Eingang, d.h. der erste Eingang des ersten Multiplexers 306, an dem die erste Vorverzerrungskomponente $p_1(n)$ anliegt, ausgewählt. Ist der Wert der Steuerfunktion Eins, so wird der "1"-Eingang, d. h. der zweite Eingang des ersten Multiplexers 306, an dem die zweite Vorverzerrungskomponente $p_2(n)$ anliegt, ausgewählt. Die Steuerfunktion m(n) zum Wechsel zwischen der Gleichung 13 und der Gleichung 14 entspricht der Steuerfunktion m(n) aus Gleichung 22.

Der zweite Multiplexer 308 führt die Auswahl der für den zweiten Summanden von Gleichung 13 bzw. 14 verwendeten Vorverzerrungskomponente, hier $p_2(n)$ bzw. $p_1(n)$ durch, d. h. bewirkt die oben beschriebene wechselnde Multiplikation des zweiten Multiplizierers 316. Abhängig von dem Wert der Steuerfunktion m(n) der Steuereinrichtung 319 wählt der zweite Multiplexer 308 synchron zu dem ersten Multiplexer 306 entweder den ersten oder den zweiten Eingang desselben aus. Ist der Wert der Steuerfunktion m(n) abhängig von n Null, so wird der "0"-Eingang, d. h. der erste Eingang des zweiten Multiplexers 308, an dem die invertierte zweite Vorverzerrungskomponente $-p_2(n)$ des Vorverzerrungssignals anliegt, ausgewählt. Ist der Wert der Steuerfunktion Eins, wo wird der "1"-Eingang, d. h. der zweite Eingang des zweiten Multiplexers 308, an dem die erste Vorverzerrungskomponente $p_1(n)$ des Vorverzerrungssignals anliegt, ausgewählt.

Ein Vorteil des I/Q-Modulators 300 mit Trägervorverzerrung gemäß dem dritten Ausführungsbeispiel der vorliegenden Erfindung besteht darin, daß derselbe im Vergleich zu einem herkömmlichen I/Q-Modulator mit Vorverzerrung des I/Q-Signals lediglich zwei anstatt sechs Multiplizierer aufweist, wodurch ferner die Anzahl der Gatter als auch der Leistungsverbrauch reduziert werden.

Die Einrichtungen 112, 216 und 312 zum Erzeugen eines Vorverzerrungssignals in Fig. 1, 2 und 3, die zum Erzeugen des Vorverzerrungssignals bzw. der ersten Vorverzerrungskomponente und der zweiten Vorverzerrungskomponente dienen, erzeugen das Vorverzerrungssignal $\underline{p}(t)$ mindestens in Abhängigkeit von der I- und der Q-Komponente i(t), q(t) des I/Q-Signals.

$$\underline{p}(t) = \underline{p}[\underline{x}(t)] = \underline{p}[i(t),\ q(t)] \qquad\qquad \text{Glg. 29.}$$

Die jeweilige Einrichtung zum Erzeugen eines Vorverzerrungssignals kann eine Tabelle sein, die abhängig vom Zustand des I/Q-Signals, d. h. der Amplitude desselben, adressiert wird, um die erste und die zweite Vorverzerrungskomponente auszugeben. Die Tabelle kann jedoch ferner mit anderen optionalen Parametern adressiert werden. Diese anderen optionalen Parameter können bei dem Beispiel einer Sendeeinrichtung nach Fig. 4, in die der I/Q-Modulator eingebaut sein kann, z. B. die Temperaturabhängigkeit, das Alterungsverhalten, Leistungsvariationen etc. der Sendeeinrichtung und vor allem des darin enthaltenen Sendeverstärkers berücksichtigen. Die Tabelle wird entsprechend der Anzahl der weiteren optionalen Parameter größer. Die Tabelle kann ferner eine dynamische Tabelle sein, die variable Tabellenwerte aufweist. Die Inhalte dieser dynamischen Tabelle können, z. B. bei der Sendeeinrichtung von Fig. 4, abhängig von einem Vergleich eines ursprünglichen I/Q-Signals, das in die dem I/Q-Modulator folgenden verzerrenden Elemente der Sendeeinrichtung gespeist wurde, mit einem Signal, das von diesen Elementen ausgegeben wird, eingestellt werden, um die Vorverzerrung des I/Q-Signals mittels der Tabelle, d. h. mittels des Vorverzerrungssignals, zu jedem beliebigen Zeitpunkt optimal dynamisch einzustellen. Dies geschieht, wie bereits in Fig. 4 beschrieben, beispielsweise über ein Rückführung und wird adaptive Vorverzerrung des I/Q-Signals genannt.

Die I/Q-Modulatoren mit Vorverzerrung des I/Q-Signals und mit Trägervorverzerrung gemäß der Erfindung bieten durch ihre reduzierte Anzahl an Multiplizierern wesentliche Strukturvorteile gegenüber herkömmlichen I/Q-Modulatoren mit Vorverzerrung des I/Q-Signals. Es können strukturvereinfachte und energieeffiziente I/Q-Modulatoren realisiert werden.

**Patentansprüche**

1. I/Q-Modulator (100; 300) zum Verarbeiten eines zeitdiskreten I/Q-Signals, das eine I-Komponente (i) und eine dazu im wesentlichen orthogonale Q-Komponente (q) aufweist, wobei dem I/Q-Signal eine Abtastfrequenz zugrunde liegt, die im wesentlichen viermal so groß wie eine Trägerfrequenz eines Trägersignals ist, auf das das I/Q-Signal zu modulieren ist, mit folgenden Merkmalen:

   - einer Vorverzerrungseinrichtung (102; 302) zum Vorverzerren der I- und der Q-Komponente mit einem Vorverzerrungssignal, das von der I- und der Q-Komponente abhängt, und eine erste und eine zweite Vorverzerrungskomponente ($p_1$, $p_2$) aufweist, wobei die Vorverzerrungseinrichtung (102; 302) angeordnet ist, um eine vorverzerrte I-Komponente als Differenz zwischen der I-Komponente (i) multipliziert mit der ersten Vorverzerrungskomponente ($p_1$) und der Q-Komponente (q) multipliziert mit der zweiten Vorverzerrungskomponente ($p_2$) zu bilden, und dazu zeitlich abwechselnd eine vorverzerrte Q-Komponente als Summe der I-Komponente (i) multipliziert mit der zweiten Vorverzerrungskomponente ($p_2$) und der Q-Komponente (q) multipliziert mit der ersten Vorverzerrungskomponente ($p_1$) zu bilden, um ein vorverzerrtes Ausgangssignal (v) zu erhalten; und

   - einer Einrichtung (104; 304) zum Einstellen der Vorzeichen der sich zeitlich abwechselnden vorverzerrten I-Komponenten und vorverzerrten Q-Komponenten des vorverzerrten Ausgangssignals (v), so daß zwei zeitlich aufeinanderfolgende vorverzerrte Komponenten ein erstes Vorzeichen aufweisen und zwei weitere aufeinanderfolgende vorverzerrte Komponenten, die denselben zeitlich folgen, ein zweites Vorzeichen aufweisen, das zu dem ersten Vorzeichen invers ist, um ein Ausgangssignal (y) an einem Ausgang des I/Q-Modulators (100; 300) zu erzeugen.

2. I/Q-Modulator (100) gemäß Anspruch 1, bei dem die Vorverzerrungseinrichtung (102) folgende Merkmale aufweist:

   - einen ersten Multiplizierer (114) zum Multiplizieren von entweder der I-Komponente (i) oder der Q-Komponente (q) mit der ersten Vorverzerrungskomponente ($p_1$), um eine multiplizierte erste Vorverzerrungskomponente zu erhalten;

   - einen zweiten Multiplizierer (116) zum Multiplizieren von entweder der invertierten Q-Komponente (q) oder der I-Komponente (i) mit der zweiten Vorverzerrungskomponente ($p_2$), um eine multiplizierte zweite Vorverzerrungskomponente zu erhalten;

   - einen Addierer (118) zum Addieren der multiplizierten ersten Vorverzerrungskomponente und der multiplizierten zweiten Vorverzerrungskomponente, um das vorverzerrte Ausgangssignal (v) zu erzeugen;

   - einen ersten Multiplexer (106), der einen ersten und einen zweiten Eingang aufweist, wobei der erste Eingang mit der I-Komponente (i) speisbar ist, und wobei der zweite Eingang mit der Q-Komponente (q) speisbar ist, und einen Ausgang aufweist, der mit dem ersten Multiplizierer (114) gekoppelt ist;

   - einen zweiten Multiplexer (108), der einen ersten und einen zweiten Eingang aufweist, wobei der erste Eingang mit der invertierten Q-Komponente (q) speisbar ist, und wobei der zweite Eingang mit der I-Komponente (i) speisbar ist, und einen Ausgang aufweist, der mit dem zweiten Multiplizierer (116) gekoppelt ist; und

   - eine Steuereinrichtung (119) zum Erzeugen eines Steuersignals (m), um den ersten oder zweiten Eingang des ersten Multiplexers (106) und des zweiten Multiplexers (108) mit dem jeweiligen Ausgang zu verbinden, wobei die Steuereinrichtung (119) angeordnet ist, um das Steuersignal (m) als Rest einer ganzzahligen Division eines zeitlichen Index (n) des zeitdiskreten I/Q-Signals mit der Zahl 2 zu erzeugen.

3. I/Q-Modulator (300) gemäß Anspruch 1, bei dem die Vorverzerrungseinrichtung (302) folgende Merkmale aufweist:

- einen ersten Multiplizierer (314) zum Multiplizieren der I-Komponente (i) mit entweder der ersten Vorverzerrungskomponente ($p_1$) oder der zweiten Vorverzerrungskomponente ($p_2$) des Vorverzerrungssignals, um eine multiplizierte I-Komponente zu erhalten;

- einen zweiten Multiplizierer (316) zum Multiplizieren der Q-Komponente mit entweder der invertierten zweiten Vorverzerrungskomponente ($p_2$) oder der ersten Vorverzerrungskomponente ($p_1$) des Vorverzerrungssignals, um eine multiplizierte Q-Komponente zu erhalten;

- einen Addierer (318) zum Addieren der multiplizierten I-Komponente und der multiplizierten Q-Komponente, um das vorverzerrte Ausgangssignal (v) zu erzeugen;

- einen ersten Multiplexer (306), der einen ersten und einen zweiten Eingang aufweist, wobei der erste Eingang mit der ersten Vorverzerrungskomponente ($p_1$) speisbar ist, und wobei der zweite Eingang mit der zweiten Vorverzerrungskomponente ($p_2$) speisbar ist, und einen Ausgang aufweist, der mit dem ersten Multiplizierer (314) gekoppelt ist;

- einen zweiten Multiplexer (308), der einen ersten und einen zweiten Eingang aufweist, wobei der erste Eingang mit der invertierten zweiten Vorverzerrungskomponente ($p_2$) speisbar ist, und wobei der zweite Eingang mit der ersten Vorverzerrungskomponente ($p_1$) speisbar ist, und einen Ausgang aufweist, der mit dem zweiten Multiplizierer (316) gekoppelt ist; und

- eine Steuereinrichtung (319) zum Erzeugen eines Steuersignals (m), um den ersten oder zweiten Eingang des ersten Multiplexers (306) und des zweiten Multiplexers (308) mit dem jeweiligen Ausgang zu verbinden, wobei die Steuereinrichtung (319) angeordnet ist, um das Steuersignal (m) als Rest einer ganzzahligen Division eines zeitlichen Index (n) des zeitdiskreten I/Q-Signals mit der Zahl 2 zu erzeugen.

4. I/Q-Modulator (100; 300) gemäß einem der Ansprüche 1 bis 3, bei dem die Einrichtung (104; 304) zum Einstellen der Vorzeichen folgende Merkmale aufweist:

- einen Multiplexer (120; 320) mit einem ersten und einem zweiten Eingang und einem Ausgang, wobei der erste Eingang mit dem vorverzerrten Ausgangssignal (v) speisbar ist, und wobei der zweite Eingang mit dem invertierten vorverzerrten Ausgangssignal (v) der Vorverzerrungseinrichtung (102; 302) speisbar ist; und

- eine Steuereinrichtung (123; 323) zum Erzeugen eines Steuersignals (s), um den ersten oder den zweiten Eingang des Multiplexers (120; 320) mit dem Ausgang des I/Q-Modulators (100; 300) zu verbinden, wobei die Steuereinrichtung (123; 323) angeordnet ist, um das Steuersignal (s) als Rest einer ganzzahligen Division zwischen einer Variablen und der Zahl 2 zu erzeugen, wobei die Variable gleich dem Ergebnis einer ganzzahligen Division des mit Eins inkrementierten zeitlichen Index (n) des zeitdiskreten I/Q-Signals und der Zahl 2 ist.

5. I/Q-Modulator (200) zum Verarbeiten eines zeitdiskreten I/Q-Signals, das eine I-Komponente (i) und eine dazu im wesentlichen orthogonale Q-Komponente (q) aufweist, wobei dem I/Q-Signal eine Abtastfrequenz zugrunde liegt, die im wesentlichen viermal so groß wie eine Trägerfrequenz eines Trägersignals ist, auf das das I/Q-Signal zu modulieren ist, mit folgenden Merkmalen:

- einem ersten Multiplizierer (206) zum Multiplizieren der I-Komponente (i) mit einer vorverzerrten ersten Teilkomponente ($t_1$) des Trägersignals, um eine multiplizierte I-Komponente zu erhalten;

- einem zweiten Multiplizierer (208) zum Multiplizieren der Q-Komponente (q) mit einer vorverzerrten zweiten Teilkomponente ($t_2$) des Trägersignals, um eine multiplizierte Q-Komponente zu erhalten;

- einem Addierer (210) zum Addieren der multiplizierten I-Komponente und der invertierten multiplizierten Q-Komponente; und

- einer Vorverzerrungseinrichtung (201) zum Vorverzerren eines Trägersignals, um ein vorverzerrtes Trägersignal, das eine erste und eine zweite vorverzerrte Teilkomponente ($t_1$, $t_2$) aufweist, aus einem Vorverzerrungssignal zu erzeugen, das von der I-Komponente (i) und der Q-Komponente (q) abhängt und eine erste Vorverzerrungskomponente ($p_1$) und eine zweite Vorverzerrungskomponente ($p_2$) aufweist, wobei die Vorverzerrungseinrichtung (201) angeordnet ist, um als vorverzerrte erste Teilkomponente ($t_1$) des Trägersignals zeitlich

14

abwechselnd die erste und die zweite Vorverzerrungskomponente ($p_1$, $p_2$) auszuwählen, wobei bei einer Gruppe von vier zeitlich aufeinanderfolgenden ausgewählten Vorverzerrungskomponenten für die vorverzerrte erste Teilkomponente ($t_1$) des Trägersignals das Vorzeichen der zweiten und der dritten ausgewählten Vorverzerrungskomponente der Gruppe invertiert wird, und wobei die Vorverzerrungseinrichtung (201) ferner angeordnet ist, um als vorverzerrte zweite Teilkomponente ($t_2$) des Trägersignals zeitlich abwechselnd die zweite und die erste Vorverzerrungskomponente ($p_2$, $p_1$) auszuwählen, wobei bei einer Gruppe von vier zeitlich aufeinanderfolgenden ausgewählten Vorverzerrungskomponenten für die vorverzerrte zweite Teilkomponente ($t_2$) des Trägersignals das Vorzeichen der dritten und der vierten ausgewählten Vorverzerrungskomponente der Gruppe invertiert wird, und wobei die vorverzerrte erste Teilkomponente ($t_1$) des Trägersignals zu einem Zeitpunkt gleich der Vorverzerrungskomponente ist, zu der die vorverzerrte zweite Teilkomponente ($t_2$) des Trägersignals nicht gleich ist.

6. I/Q-Modulator (200) gemäß Anspruch 5, bei dem die Vorverzerrungseinrichtung (201) folgende Merkmale aufweist:

- einen ersten Multiplexer (202), der einen ersten, einen zweiten, einen dritten und einen vierten Eingang aufweist, wobei der erste Eingang mit der ersten Vorverzerrungskomponente ($p_1$) speisbar ist, der zweite Eingang mit der zweiten Vorverzerrungskomponente ($p_2$) speisbar ist, der dritte Eingang mit der invertierten ersten Vorverzerrungskomponente ($p_1$) speisbar ist, und der vierte Eingang mit der invertierten zweiten Vorverzerrungskomponente ($p_2$) speisbar ist, und einen Ausgang aufweist, der die erste vorverzerrte Teilkomponente ($t_1$) des Trägersignals liefert und mit dem ersten Multiplizierer (206) gekoppelt ist;

- einen zweiten Multiplexer (204), der einen ersten, einen zweiten, einen dritten und einen vierten Eingang aufweist, wobei der erste Eingang mit der invertierten zweiten Vorverzerrungskomponente ($p_2$) speisbar ist, der zweite Eingang mit der ersten Vorverzerrungskomponente ($p_1$) speisbar ist, der dritte Eingang mit der zweiten Vorverzerrungskomponente ($p_2$) speisbar ist, und der vierte Eingang mit der invertierten ersten Vorverzerrungskomponente ($p_1$) speisbar ist, und einen Ausgang aufweist, der die zweite vorverzerrte Teilkomponente ($t_2$) des Trägersignals liefert und mit dem zweiten Multiplizierer (208) gekoppelt ist; und

- eine Steuereinrichtung (217) zum Erzeugen eines Steuersignals (1), um den ersten, den zweiten, den dritten und den vierten Eingang des ersten Multiplexers (202) und des zweiten Multiplexers (204) mit dem jeweiligen Ausgang zu verbinden, wobei die Steuereinrichtung (217) angeordnet ist, um das Steuersignal (1) als Rest einer ganzzahligen Division eines zeitlichen Index (n) des zeitdiskreten I/Q-Signals mit der Zahl 4 zu erzeugen.

7. I/Q-Modulator (100; 200; 300) gemäß einem der vorhergehenden Ansprüche bei dem die Vorverzerrungseinrichtung (102; 201; 302) ferner folgendes Merkmal aufweist:

- eine Einrichtung (112; 216; 312) zum Erzeugen eines Vorverzerrungssignals, die das Vorverzerrungssignal mindestens abhängig von der I-Komponente (i) und der Q-Komponente (q) des I/Q-Signals erzeugt, und die einen ersten Eingang, der mit der I-Komponente (i) des I/Q-Signals speisbar ist, einen zweiten Eingang, der mit der Q-Komponente (q) des I/Q-Signals speisbar ist, einen ersten Ausgang, der die erste Vorverzerrungskomponente ($p_1$) des Vorverzerrungssignals liefert, und einen zweiten Ausgang, der die zweite Vorverzerrungskomponente ($p_2$) des Vorverzerrungssignals liefert, aufweist.

8. I/Q-Modulator (100; 200; 300) gemäß Anspruch 7, bei dem die Einrichtung (112; 216; 312) zum Erzeugen eines Vorverzerrungssignals das Vorverzerrungssignal ferner abhängig von mindestens einem weiteren Parameter erzeugt, der die das I/Q-Signal verzerrenden Eigenschaften einer Einrichtung beschreibt, die den I/Q-Modulator umfaßt.

9. I/Q-Modulator (100; 200; 300) gemäß Anspruch 8, bei dem die Einrichtung, in der der I/Q-Modulator umfaßt ist, eine Sendeeinrichtung ist, und der mindestens eine Parameter die altersabhängigen, temperaturabhängigen und die von Leistungsschwankungen abhängigen verzerrenden Eigenschaften der Sendeeinrichtung berücksichtigt.

10. I/Q-Modulator (100; 200; 300) gemäß Anspruch 8 oder 9, bei dem die Einrichtung (112; 216; 312) zum Erzeugen eines Vorverzerrungssignals die so angeordnet ist, daß sie das Vorverzerrungssignal ferner abhängig von einem Vergleich des in den I/Q-Modulator (100; 200; 300) gespeisten I/Q-Signals oder aus dem I/Q-Modulator kommenden vorverzerrten I/Q-Signals mit einem durch die Einrichtung, in der der I/Q-Modulator (100; 200; 300) umfaßt ist, verzerrten I/Q-Signal einstellt.

**11.** I/Q-Modulator (100; 200; 300) gemäß einem der Ansprüche 7 bis 10, bei dem die Einrichtung (112; 216; 312) zum Erzeugen eines Vorverzerrungssignals eine Tabelle ist, die so angeordnet ist, daß sie durch die I-Komponente (i) und die Q-Komponente (q) des I/Q-Signals oder durch die I-Komponente (i), die Q-Komponente (q) des I/Q-Signals und den mindestens einen weiteren Parameter in Abhängigkeit von dem zeitlichen Index (n) adressiert wird.

**12.** Verfahren zum Verarbeiten eines zeitdiskreten I/Q-Signals, das eine I-Komponente (i) und eine dazu im wesentlichen orthogonale Q-Komponente (q) aufweist, wobei dem I/Q-Signal eine Abtastfrequenz zugrunde liegt, die im wesentlichen viermal so groß wie eine Trägerfrequenz eines Trägersignals ist, auf das das I/Q-Signal zu modulieren ist, mit folgenden Schritten:

- Vorverzerren der I- und der Q-Komponente mit einem Vorverzerrungssignal, das von der I- und der Q-Komponente abhängt, und eine erste und eine zweite Vorverzerrungskomponente ($p_1$, $p_2$) aufweist, wobei das Vorverzerren derart ausgeführt wird, das eine vorverzerrte I-Komponente als Differenz zwischen der I-Komponente (i) multipliziert mit der ersten Vorverzerrungskomponente ($p_1$) und der Q-Komponente (q) multipliziert mit der zweiten Vorverzerrungskomponente ($p_2$) gebildet wird, und dazu zeitlich abwechseln eine vorverzerrte Q-Komponente als Summe der I-Komponente (i) multipliziert mit der zweiten Vorverzerrungskomponente ($p_2$) und der Q-Komponente (q) multipliziert mit der ersten Vorverzerrungskomponente ($p_1$) gebildet wird, um ein vorverzerrtes Ausgangssignal (v) zu erhalten; und

- Einstellen der Vorzeichen der sich zeitlich abwechselnden vorverzerrten I-Komponenten und vorverzerrten Q-Komponenten des vorverzerrten Ausgangssignals (v), so daß zwei zeitlich aufeinanderfolgende vorverzerrte Komponenten ein erstes Vorzeichen aufweisen und zwei weitere aufeinanderfolgende vorverzerrte Komponenten, die denselben zeitlich folgen, ein zweites Vorzeichen aufweisen, das zu dem ersten Vorzeichen invers ist, um ein Ausgangssignal (y) zu erzeugen.

**13.** Verfahren zum Verarbeiten eines zeitdiskreten I/Q-Signals, das eine I-Komponente (i) und eine dazu im wesentlichen orthogonale Q-Komponente (q) aufweist, wobei dem I/Q-Signal eine Abtastfrequenz zugrunde liegt, die im wesentlichen viermal so groß wie eine Trägerfrequenz eines Trägersignals ist, auf das das I/Q-Signal zu modulieren ist, mit folgenden Schritten:

- Multiplizieren der I-Komponente (i) mit einer vorverzerrten ersten Teilkomponente ($t_1$) des Trägersignals, um eine multiplizierte I-Komponente zu erhalten;

- Multiplizieren der Q-Komponente (q) mit einer vorverzerrten zweiten Teilkomponente ($t_2$) des Trägersignals, um eine multiplizierte Q-Komponente zu erhalten;

- Addieren der multiplizierten I-Komponente und der invertierten multiplizierten Q-Komponente; und

- Vorverzerren des Trägersignals, um ein vorverzerrtes Trägersignal, das eine erste und eine zweite vorverzerrte Teilkomponente ($t_1$, $t_2$) aufweist, aus einem Vorverzerrungssignal zu erzeugen, das von der I-Komponente (i) und der Q-Komponente (q) abhängt und eine erste Vorverzerrungskomponente ($p_1$) und eine zweite Vorverzerrungskomponente ($p_2$) aufweist, wobei das Vorverzerren derart ausgeführt wird, daß als vorverzerrte erste Teilkomponente ($t_1$) des Trägersignals zeitlich abwechseln die erste und die zweite Vorverzerrungskomponente ($p_1$, $p_2$) ausgewählt wird, wobei bei einer Gruppe von vier zeitlich aufeinanderfolgenden ausgewählten Vorverzerrungskomponenten für die vorverzerrte erste Teilkomponente ($t_1$) des Trägersignals das Vorzeichen der zweiten und der dritten ausgewählten Vorverzerrungskomponente der Gruppe invertiert wird, und wobei das Vorverzerren ferner derart ausgeführt wird, daß als vorverzerrte zweite Teilkomponente ($t_2$) des Trägersignals zeitlich abwechseln die zweite und die erste vorverzerrungskomponente ($p_2$, $p_1$) ausgewählt wird, wobei bei einer Gruppe von vier zeitlich aufeinanderfolgenden ausgewählten Vorverzerrungskomponenten für die vorverzerrte zweite Teilkomponente ($t_2$) des Trägersignals das Vorzeichen der dritten und der vierten ausgewählten Vorverzerrungskomponente der Gruppe invertiert wird, und wobei die vorverzerrte erste Teilkomponente ($t_1$) des Trägersignals zu einem Zeitpunkt gleich der Vorverzerrungskomponente ist, zu der die vorverzerrte zweite Teilkomponente ($t_2$) des Trägersignals nicht gleich ist.

**Claims**

**1.** An I/Q modulator (100; 300) for processing a time-discrete I/Q signal comprising an I component (i) and a Q component (q) which is substantially orthogonal thereto, the I/Q signal being based on a sampling frequency which is equal to substantially four times a carrier frequency of a carrier signal onto which the I/Q signal is to be modulated, said I/Q modulator comprising:

predistortion means (102; 302) for predistorting the I component and the Q component with a predistortion signal which depends on the I component and the Q component and which comprises a first predistortion component ($p_1$) and a second predistortion component ($p_2$), the predistortion means (102; 302) being arranged for forming a predistorted I component as a difference between the I component (i) multiplied by the first predistortion component ($p_1$) and the Q component (q) multiplied by the second predistortion component ($p_2$) and for forming, in temporal alternation therewith, a predistorted Q component as a sum of the I component (i) multiplied by the second predistortion component ($p_2$) and of the Q component (q) multiplied by the first predistortion component ($p_1$), so as to obtain a predistorted output signal (v); and

means (104; 304) for adjusting the signs of the temporally alternating predistorted I components and predistorted Q components of the predistorted output signal (v) so that two temporally successive predistorted components have a first sign and two additional successive predistorted components, which follow said first-mentioned components in time, have a second sign, which is inverse to said first sign, so as to produce an output signal (y) at an output of the I/Q modulator (100; 300).

2. An I/Q modulator (100) according to claim 1, wherein the predistortion means (102) comprises:

a first multiplier (114) for multiplying either the I component (i) or the Q component (q) by the first predistortion component ($p_1$) so as to obtain a multiplied first predistortion component;

a second multiplier (116) for multiplying either the inverted Q component (q) or the I component (i) by the second predistortion component ($p_2$) so as to obtain a multiplied second predistortion component;

an adder (118) for adding the multiplied first predistortion component and the multiplied second predistortion component so as to produce the predistorted output signal (v);

a first multiplexer (106) comprising a first and a second input, said first input being adapted to be fed with the I component (i), and said second input being adapted to be fed with the Q component (q), and an output coupled to said first multiplier (114);

a second multiplexer (108) comprising a first and a second input, said first input being adapted to be fed with the inverted Q component (q), and the second input being adapted to be fed with the I component (i), and an output coupled to said second multiplier (116); and

a control unit (119) for producing a control signal (m) so as to connect the first or the second input of the first multiplexer (106) and of the second multiplexer (108) with the respective output, said control unit (119) being arranged for producing the control signal (m) as divide remainder of a whole-number division of a time index (n) of the time-discrete I/Q signal with the number 2.

3. An I/Q modulator (300) according to claim 1, wherein the predistortion means (302) comprises:

a first multiplier (314) for multiplying the I component (i) by either the first predistortion component ($p_1$) or the second predistortion component ($p_2$) of the predistortion signal so as to obtain a multiplied I component;

a second multiplier (316) for multiplying the Q component by either the inverted second predistortion component ($p_2$) or the first predistortion component ($p_1$) of the predistortion signal so as to obtain a multiplied Q component;

an adder (318) for adding the multiplied I component and the multiplied Q component so as to obtain the predistorted output signal (v);

a first multiplier (306) comprising a first and a second input, said first input being adapted to be fed with the first predistortion component ($p_1$), and said second input being adapted to be fed with the second predistortion component ($p_2$), and an output coupled to said first multiplier (314);

a second multiplexer (308) comprising a first and a second input, said first input being adapted to be fed with the inverted second predistortion component ($p_2$), and said second input being adapted to be fed with the first predistortion component ($p_1$), and an output coupled to said second multiplier (316); and

a control unit (319) for producing a control signal (m) so as to connect the first or the second input of the first multiplexer (306) and of the second multiplexer (308) to the respective output, said control unit (319) being arranged for producing the control signal (m) as divide remainder of a whole-number division of a time index (n) of the time-discrete I/Q signal with the number 2.

4. An I/Q modulator (100; 300) according to one of the claims 1 to 3, wherein the means (104; 304) for adjusting the signs comprises:

a multiplexer (120; 320) comprising a first and a second input and an output, said first input being adapted to be fed with the predistorted output signal (v), and said second input being adapted to be fed with the inverted predistorted output signal (v) of the predistortion means (102; 302); and

a control unit (123; 323) for producing a control signal (s) so as to connect the first or the second input of the multiplexer (120; 320) to the output of the I/Q modulator (100; 300), the control unit (123; 323) being arranged for producing the control signal (s) as a divide remainder of a whole-number division of a variable with the number 2, said variable being equal to the result of a whole-number division with the number 2 of the time index (n), incremented by 1, of the time-discrete I/Q signal.

5. An I/Q modulator (200) for processing a time-discrete I/Q signal comprising an I component (i) and a Q component (q) which is substantially orthogonal thereto, the I/Q signal being based on a sampling frequency which is equal to substantially four times a carrier frequency of a carrier signal onto which the I/Q signal is to be modulated, said I/Q modulator comprising:

a first multiplier (206) for multiplying the I component (i) by a predistorted first subcomponent ($t_1$) of the carrier signal so as to obtain a multiplied I component;

a second multiplier (208) for multiplying the Q component (q) by a predistorted second subcomponent ($t_2$) of the carrier signal so as to obtain a multiplied Q component;

an adder (210) for adding the multiplied I component and the inverted multiplied Q component; and

predistortion means (201) for predistorting a carrier signal so as to produce a predistorted carrier signal, which comprises first and second predistorted subcomponents ($t_1$, $t_2$), from a predistortion signal which depends on the I component (i) and on the Q component (q) and which comprises a first predistortion component ($p_1$) and a second predistortion component ($p_2$), said predistortion means (201) being arranged for selecting, in temporal alternation, the first predistortion component ($p_1$) and the second predistortion component ($p_2$) as predistorted first subcomponent ($t_1$) of the carrier signal, wherein in a group of four temporally successive selected predistortion components for the predistorted first subcomponent ($t_1$) of the carrier signal the signs of the second and third selected predistortion components of said group are inverted, and said predistortion means (201) being additionally arranged for selecting, in temporal alternation, the second predistortion component ($p_2$) and the first predistortion component ($p_1$) as predistorted second subcomponent ($t_2$) of the carrier signal, wherein in a group of four temporally successive selected predistortion components for the predistorted second subcomponent ($t_2$) of the carrier signal the signs of the third and fourth selected predistortion components of said group are inverted, and wherein the predistorted first subcomponent ($t_1$) of the carrier signal is equal to the predistortion component at a time instant at which the predistorted second subcomponent ($t_2$) of the carrier signal is not equal.

6. An I/Q modulator (200) according to claim 5, wherein the predistortion means (201) comprises:

a first multiplexer (202) comprising a first, a second, a third and a fourth input, said first input being adapted to be fed with the first predistortion component ($p_1$), said second input being adapted to be fed with the second predistortion component ($p_2$), said third input being adapted to be fed with the inverted first predistortion component ($p_1$), and said fourth input being adapted to be fed with the inverted second predistortion component ($p_2$), and an output which supplies the first predistorted subcomponent ($t_1$) of the carrier signal and which is coupled to the first multiplier (206);

a second multiplexer (204) comprising a first, a second, a third and a fourth input, said first input being adapted to be fed with the inverted second predistortion component ($p_2$), said second input being adapted to be fed with the first predistortion component ($p_1$), said third input being adapted to be fed with the second predistortion component ($p_2$), and said fourth input being adapted to be fed with the inverted first predistortion component ($p_1$), and an output which supplies the second predistorted subcomponent ($t_2$) of the carrier signal and which is coupled to the second multiplier (208); and

a control unit (217) for producing a control signal (1) so as to connect the first, the second, the third and the fourth input of the first multiplexer (202) and of the second multiplexer (204) to the respective output, said control unit (217) being arranged for producing said control signal (1) as divide remainder of a whole-number division of a time index (n) of the time-discrete I/Q signal with the number.

7. An I/Q modulator (100; 200; 300) according to one of the preceding claims, wherein the predistortion means (102; 201; 302) additionally comprises:

means (112; 216; 312) for producing a predistortion signal, which produces the predistortion signal at least in dependence upon the I component (i) and the Q component (q) of the I/Q signal and which comprises a first input that is adapted to be fed with the I component (i) of the I/Q signal, a second input that is adapted to be fed with Q component (q) of the I/Q signal, a first output supplying the first predistortion component ($p_1$) of the predistortion signal, and a second output supplying the second predistortion component ($p_2$) of the predistortion signal.

8. An I/Q modulator (100; 200; 300) according to claim 7, wherein the means (112; 216; 312) for producing a predistortion signal produces the predistortion signal such that it additionally depends on at least one further parameter which describes the I/Q signal-distorting properties of means comprising the I/Q modulator.

9. An I/Q modulator (100; 200; 300) according to claim 8, wherein the means comprising the I/Q modulator is a transmitting means and wherein the at least one parameter takes into account the age-dependent and the temperature-dependent distorting properties of the transmitting means as well as the distorting properties of the transmitting means depending on power variations.

10. An I/Q modulator (100; 200; 300) according to claim 8 or 9, wherein the means (112; 216; 312) for producing a predistortion signal is arranged such that it adjusts the predistortion signal additionally in dependence upon a comparison between the I/Q signal fed to the I/Q modulator (100; 200; 300) or the predistorted I/Q signal coming from the I/Q modulator and an I/Q signal distorted by the means comprising the I/Q modulator (100; 200; 300).

11. An I/Q modulator (100; 200; 300) according to one of the claims 7 to 10, wherein the means (112; 216; 312) for producing a predistortion signal is a table which is arranged such that it is addressed by the I component (i) and the Q component (q) of the I/Q signal, or by the I component (i), the Q component (q) of the I/Q signal and the at least one additional parameter in dependence upon the time index (n).

12. A method of processing a time-discrete I/Q signal comprising an I component (i) and a Q component (q) which is substantially orthogonal thereto, the I/Q signal being based on a sampling frequency which is equal to substantially four times a carrier frequency of a carrier signal onto which the I/Q signal is to be modulated, said method comprising the following steps:

predistorting the I component and the Q component with a predistortion signal which depends on the I component and the Q component and which comprises a first predistortion component ($p_1$) and a second predistortion component ($p_2$), the predistortion being carried out such that a predistorted I component is formed as a difference between the I component (i) multiplied by the first predistortion component ($p_1$) and the Q component (q) multiplied by the second predistortion component ($p_2$) and that, in temporal alternation therewith, a predistorted Q component is formed as a sum of the I component (i) multiplied by the second predistortion component ($p_2$) and of the Q component (q) multiplied by the first predistortion component ($p_1$), so as to obtain a predistorted output signal (v); and

adjusting the signs of the temporally alternating predistorted I components and predistorted Q components of the predistorted output signal (v) so that two temporally successive predistorted components have a first sign and two additional successive predistorted components, which follow said first-mentioned components in time, have a second sign, which is inverse to said first sign, so as to produce an output signal (y).

13. A method of processing a time-discrete I/Q signal comprising an I component (i) and a Q component (q) which is substantially orthogonal thereto, the I/Q signal being based on a sampling frequency which is equal to substantially four times a carrier frequency of a carrier signal onto which the I/Q signal is to be modulated, said method comprising the following steps:

   multiplying the I component (i) by a predistorted first subcomponent ($t_1$) of the carrier signal so as to obtain a multiplied I component;

   multiplying the Q component (q) by a predistorted second subcomponent ($t_2$) of the carrier signal so as to obtain a multiplied Q component;

   adding the multiplied I component and the inverted multiplied Q component; and

   predistorting the carrier signal so as to produce a predistorted carrier signal, which comprises first and second predistorted subcomponents ($t_1$, $t_2$), from a predistortion signal which depends on the I component (i) and on the Q component (q) and which comprises a first predistortion component ($p_1$) and a second predistortion component ($p_2$), said predistortion being carried out such that the first predistortion component ($p_1$) and the second predistortion component ($p_2$) are selected, in temporal alternation, as predistorted first subcomponent ($t_1$) of the carrier signal, wherein in a group of four temporally successive selected predistortion components for the predistorted first subcomponent ($t_1$) of the carrier signal the signs of the second and third selected predistortion components of said group are inverted, and said predistortion being additionally carried out such that the second predistortion component ($p_2$) and the first predistortion component ($p_1$) are selected, in temporal alternation, as predistorted second subcomponent ($t_2$) of the carrier signal, wherein in a group of four temporally successive selected predistortion components for the predistorted second subcomponent ($t_2$) of the carrier signal the signs of the third and fourth selected predistortion components of said group are inverted, and wherein the predistorted first subcomponent ($t_1$) of the carrier signal is equal to the predistortion component at a time instant at which the predistorted second subcomponent ($t_2$) of the carrier signal is not equal.


**Revendications**

1. Modulateur I/Q (100 ; 300) destiné à traiter un signal I/Q discret dans le temps présentant une composante I (i) et une composante Q (q) sensiblement orthogonale à cette dernière, le signal I/Q étant basé sur une fréquence de balayage qui est substantiellement quatre fois supérieure à une fréquence de porteuse d'un signal porteur sur lequel doit être modulé le signal I/Q, aux caractéristiques suivantes :

   - un dispositif de prédistorsion (102 ; 302) destiné à prédistorsionner la composante I et la composante Q par un signal de prédistorsion qui est fonction de la composante I et de la composante Q, et qui présente une première et une deuxième composante de prédistorsion ($p_1$, $p_2$), le dispositif de prédistorsion (102 ; 302) étant disposé de manière à former une composante I prédistorsionnée comme différence entre la composante I (i) multipliée par la première composante de prédistorsion ($p_1$) et la composante Q (q) multipliée par la deuxième composante de prédistorsion ($p_2$), et pour former, alternativement dans le temps à cela, une composante Q prédistorsionnée comme somme de la composante I (i) multipliée par la deuxième composante de prédistorsion ($p_2$) et la composante Q (q) multipliée par la première composante de prédistorsion ($p_1$), afin d'obtenir un signal de sortie (v) prédistorsionné ; et
   - un dispositif (104 ; 304) destiné à régler les signes des composantes I prédistorsionnées et des composantes Q prédistorsionnées du signal de sortie (v) prédistorsionné s'alternant dans le temps, de sorte que deux composantes prédistorsionnées successives dans le temps présentent un premier signe et que deux autres composantes prédistorsionnées successives qui suivent ces dernières présentent un deuxième signe qui est inverse au premier signe, pour générer un signal de sortie (y) à une sortie du modulateur I/Q (100 ; 300).

2. Modulateur I/Q (100) selon la revendication 1, dans lequel le dispositif de prédistorsion (102) présente les caractéristiques suivantes :

- un premier multiplicateur (114) destiné à multiplier soit la composante I (i), soit la composante Q (q) par la première composante de prédistorsion ($p_1$), pour obtenir une première composante de prédistorsion multipliée ;
- un deuxième multiplicateur (116) destiné à multiplier soit la composante Q (q) inversée, soit la composante I (i) par la deuxième composante de prédistorsion ($p_2$), pour obtenir une deuxième composante de prédistorsion multipliée ;
- un additionneur (118) destiné à ajouter la première composante de prédistorsion multipliée et la deuxième composante de prédistorsion multipliée, pour générer le signal de sortie (v) prédistorsionné ;
- un premier multiplexeur (106) présentant une première et une deuxième entrée, la première entrée pouvant être alimentée par la composante I (i), et la deuxième entrée pouvant être alimentée par la composante Q (q), et une sortie qui est couplée au premier multiplicateur (114) ;
- un deuxième multiplexeur (108) présentant une première et une deuxième entrée, la première entrée pouvant être alimentée par la composante Q (q) inversée, et la deuxième entrée pouvant être alimentée par la composante I (i), et une sortie qui est couplée au deuxième multiplicateur (116) ; et
- un dispositif de commande (119) destiné à générer un signal de commande (m), pour relier la première ou deuxième entrée du premier multiplexeur (106) et du deuxième multiplexeur (108) à la sortie respective, le dispositif de commande (119) étant disposé de manière à générer le signal de commande (m) comme reste d'une division à nombre entier d'un indice dans le temps (n) du signal I/Q discret dans le temps par le nombre 2.

3. Modulateur I/Q (300) selon la revendication 1, dans lequel le dispositif de prédistorsion (302) présente les caractéristiques suivantes :

- un premier multiplicateur (314) destiné à multiplier la composante I (i) par soit la première composante de prédistorsion ($p_1$), soit la deuxième composante de prédistorsion ($p_2$) du signal de prédistorsion, pour obtenir une composante I multipliée ;
- un deuxième multiplicateur (316) destiné à multiplier la composante Q par soit la deuxième composante de prédistorsion ($p_2$) inversée, soit la première composante de prédistorsion ($p_1$) du signal de prédistorsion, pour obtenir une composante Q multipliée ;
- un additionneur (313) destiné à additionner la composante I multipliée et la composante Q multipliée, pour générer le signal de sortie (v) prédistorsionné ;
- un premier multiplexeur (306) présentant une première et une deuxième entrée, la première entrée pouvant être alimentée par la première composante de prédistorsion ($p_1$), et la deuxième entrée pouvant être alimentée par la deuxième composante de prédistorsion ($p_2$), et une sortie qui est couplée au premier multiplicateur (314) ;
- un deuxième multiplexeur (308) présentant une première et une deuxième entrée, la première entrée pouvant être alimentée par la deuxième composante de prédistorsion ($p_2$) inversée, et la deuxième entrée pouvant être alimentée par la première composante de prédistorsion ($p_1$), et une sortie qui est couplée au deuxième multiplicateur (316) ; et
- un dispositif de commande (319) destiné à générer un signal de commande (m), pour relier la première ou la deuxième entrée du premier multiplexeur (306) et du deuxième multiplexeur (308) à la sortie respective, le dispositif de commande (319) étant disposé de manière à générer le signal de commande (m) comme reste d'une division à nombre entier d'un indice dans le temps (n) du signal I/Q discret dans le temps par le nombre 2.

4. Modulateur I/Q (100 ; 300) selon l'une des revendications 1 à 3, dans lequel le dispositif (104 ; 304) destiné à régler les signes présente les caractéristiques suivantes :

- un multiplexeur (120 ; 320) avec une première et une deuxième entrée et une sortie, la première entrée pouvant être alimentée par le signal de sortie (v) prédistorsionné, et la deuxième entrée pouvant être alimentée par le signal de sortie (v) prédistorsionné inversé du dispositif de prédistorsion (102 ; 302) ; et
- un dispositif de commande (123 ; 323) destiné à générer un signal de commande (s), pour relier la première ou la deuxième entrée du multiplexeur (120 ; 320) à la sortie du modulateur I/Q (100 ; 300), le dispositif de commande (123 ; 323) étant disposé de manière à générer le signal de commande (s) comme reste d'une division à nombre entier entre une variable et le nombre 2, la variable étant égale au résultat d'une division à nombre entier de l'indice dans le temps (n) incrémenté de un du signal I/Q discret dans le temps et le nombre 2.

5. Modulateur I/Q (200) destiné à traiter un signal I/Q discret dans le temps présentant une composante I (i) et une composante Q (q) sensiblement orthogonale à cette dernière, le signal I/Q étant basé sur une fréquence de balayage qui est substantiellement quatre fois supérieure à une fréquence de porteuse d'un signal porteur sur lequel doit être modulé le signal I/Q, aux caractéristiques suivantes :

- un premier multiplicateur (206) destiné à multiplier la composante I (i) par une première composante partielle ($t_1$) prédistorsionnée du signal porteur, pour obtenir une composante I multipliée ;
- un deuxième multiplicateur (208) destiné à multiplier la composante Q (q) par une deuxième composante partielle ($t_2$) prédistorsionnée du signal porteur, pour obtenir une composante Q multipliée ;
- un additionneur (210) destiné à additionner la composante I multipliée et la composante Q multipliée inversée ; et

   un dispositif de prédistorsion (201) destiné à prédistorsionner un signal porteur, pour générer un signal porteur prédistorsionné présentant une première et une deuxième composante partielle ($t_1$, $t_2$) prédistorsionnées, à partir d'un signal de prédistorsion qui est fonction de la composante I (i) et de la composante Q (q) et présentant une première composante de prédistorsion ($p_1$) et une deuxième composante de prédistorsion ($p_2$), le dispositif de prédistorsion (201) étant disposé de manière à choisir, comme première composante partielle ($t_1$) prédistorsionnée du signal porteur, alternativement dans le temps, la première et la deuxième composante de prédistorsion ($p_1$, $p_2$), dans un groupe de quatre composantes de prédistorsion choisies successives dans le temps pour la première composante partielle ($t_1$) prédistorsionnée du signal porteur étant inversé le signe de la deuxième et de la troisième composante de prédistorsion choisie du groupe, et le dispositif de prédistorsion (201) étant, par ailleurs, disposé de manière à choisir, comme deuxième composante partielle ($t_2$) prédistorsionnée du signal porteur, alternativement dans le temps, la deuxième et la première composante de prédistorsion ($p_2$, $p_1$), dans un groupe de quatre composantes de prédistorsion choisies successives dans le temps pour la deuxième composante partielle ($t_2$) prédistorsionnée du signal porteur étant inversé le signe de la troisième et de la quatrième composante de prédistorsion choisie du groupe, et la première composante partielle ($t_1$) prédistorsionnée du signal porteur étant, à un moment, égale à la composante de prédistorsion à laquelle n'est pas égale la deuxième composante partielle ($t_2$) prédistorsionnée du signal porteur.

6. Modulateur I/Q (200) selon la revendication 5, dans lequel le dispositif de prédistorsion (201) présente les caractéristiques ci-après :

- un premier multiplexeur (202) présentant une première, une deuxième, une troisième et une quatrième entrée, la première entrée pouvant être alimentée par la première composante de prédistorsion ($p_1$), la deuxième entrée pouvant être alimentée par la deuxième composante de prédistorsion ($p_2$), la troisième entrée pouvant être alimentée par la première composante de prédistorsion ($p_1$) inversée, et la quatrième entrée pouvant être alimentée par la deuxième composante de prédistorsion ($p_2$) inversée, et une sortie qui fournit la première composante partielle ($t_1$) prédistorsionnée du signal porteur et qui est couplée au premier multiplicateur (206) ;
- un deuxième multiplexeur (204) présentant une première, une deuxième, une troisième et une quatrième entrée, la première entrée pouvant être alimentée par la deuxième composante de prédistorsion ($p_2$) inversée, la deuxième entrée pouvant être alimentée par la première composante de prédistorsion ($p_1$), la troisième entrée pouvant être alimentée par la deuxième composante de prédistorsion ($p_2$), et la quatrième entrée pouvant être alimentée par la première composante de prédistorsion ($p_1$) inversée, et une sortie qui fournit la deuxième composante partielle prédistorsionnée ($t_2$) du signal porteur et qui est couplée au deuxième multiplicateur (208) ; et
- un dispositif de commande (217) destiné à générer un signal de commande (1), pour relier la première, la deuxième, la troisième et la quatrième entrée du premier multiplexeur (202) et du deuxième multiplexeur (204) à la sortie respective, le dispositif de commande (217) étant disposé de manière à générer le signal de commande (1) comme reste d'une division à nombre entier d'un indice dans le temps (n) du signal I/Q discret dans le temps par le nombre 4.

7. Modulateur I/Q (100 ; 200 ; 300) selon l'une des revendications précédentes, dans lequel le dispositif de prédistorsion (102 ; 201 ; 302) présente, par ailleurs, la caractéristique suivante :

- un dispositif (112 ; 216 ; 312) destiné à générer un signal de prédistorsion qui génère le signal de prédistorsion au moins en fonction de la composante I (i) et de la composante Q (q) du signal I/Q, et qui présente une première entrée pouvant être alimentée par la composante I (i) du signal I/Q, une deuxième entrée pouvant être alimentée par la composante Q (q) du signal I/Q, une première sortie qui fournit la première composante de prédistorsion ($p_1$) du signal de prédistorsion, et une deuxième sortie qui fournit la deuxième composante de prédistorsion ($p_2$) du signal de prédistorsion.

**8.** Modulateur I/Q (100 ; 200 ; 300) selon la revendication 7, dans lequel le dispositif (112; 216 ; 312) destiné à générer un signal de prédistorsion génère, par ailleurs, le signal de prédistorsion en fonction d'au moins un autre paramètre qui décrit les propriétés distorsionnant le signal I/Q d'un dispositif comportant le modulateur I/Q.

**9.** Modulateur I/Q (100 ; 200 ; 300) selon la revendication 8, dans lequel le dispositif dans lequel est contenu le modulateur I/Q est un dispositif de transmission, et l'au moins un paramètre tient compte des propriétés de distorsion fonction du vieillissement, fonction de la température et fonction des variations de puissance du dispositif de transmission.

**10.** Modulateur I/Q (100 ; 200 ; 300) selon la revendication 8 ou 9, dans lequel le dispositif (112 ; 216 ; 312) destiné à générer un signal de prédistorsion est disposé de sorte qu'il règle le signal de prédistorsion, par ailleurs, en fonction d'une comparaison du signal I/Q alimenté vers le modulateur I/Q (100 ; 200 ; 300) ou du signal I/Q prédistorsionné issu du modulateur I/Q avec un signal I/Q distorsionné par le dispositif dans lequel est contenu le modulateur I/Q (100 ; 200 ; 300).

**11.** Modulateur I/Q (100; 200; 300) selon l'une des revendications 7 à 10, dans lequel le dispositif (112 ; 216 ; 312) destiné à générer un signal de prédistorsion est un tableau qui est disposé de sorte qu'il soit adressé par la composante I (i) et la composante Q (q) du signal I/Q ou par la composante I (i), la composante Q (q) du signal I/Q et l'au moins un autre paramètre en fonction de l'indice dans le temps (n).

**12.** Procédé pour traiter un signal I/Q discret dans le temps présentant une composante I (i) et une composante Q (q) sensiblement orthogonale à cette dernière, le signal I/Q étant basé sur une fréquence de balayage qui est substantiellement quatre fois supérieure à une fréquence de porteuse d'un signal porteur sur lequel doit être modulé le signal I/Q, aux étapes suivantes consistant à :

- prédistorsionner la composante I et la composante Q par un signal de prédistorsion qui est fonction de la composante I et de la composante Q et qui présente une première et une deuxième composante de distorsion $(p_1, p_2)$, la prédistorsion étant effectuée de sorte qu'il soit formé une composante I prédistorsionnée comme différence entre la composante I (i) multipliée par la première composante de distorsion $(p_1)$ et la composante Q (q) multipliée par la deuxième composante de prédistorsion $(p_2)$, et qu'il soit formé, alternativement dans le temps à cela, une composante Q prédistorsionnée comme somme de la composante I (i) multipliée par la deuxième composante de prédistorsion $(p_2)$ et de la composante Q (q) multipliée par la première composante de prédistorsion $(p_1)$, pour obtenir un signal de sortie (v) prédistorsionné ; et
- régler les signes des composantes I prédistorsionnées et des composants Q prédistorsionnées s'alternant dans le temps du signal de sortie (v) prédistorsionné, de sorte que deux composantes prédistorsionnées successives dans le temps présentent un premier signe et que deux autres composantes prédistorsionnées successives, qui suivent ces dernières dans le temps, présentent un deuxième signe qui est inverse au premier signe, pour générer un signal de sortie (y).

**13.** Procédé pour traiter un signal I/Q discret dans le temps présentant une composante I (i) et une composante Q (q) sensiblement orthogonale à cette dernière, le signal I/Q étant basé sur une fréquence de balayage qui est substantiellement quatre fois supérieure à une fréquence de porteuse d'un signal porteur sur lequel doit être modulé le signal I/Q, aux étapes suivantes consistant à :

- multiplier la composante I (i) par une première composante partielle $(t_1)$ prédistorsionnée du signal porteur, pour obtenir une composante I multipliée ;
- multiplier la composante Q (q) par une deuxième composante partielle $(t_2)$ prédistorsionnée du signal porteur, pour obtenir un composante Q multipliée ;
- additionner la composant I multiplié et la composante Q multipliée inversée ; et

prédistorsionner le signal porteur, pour générer un signal porteur prédistorsionné présentant une première et une deuxième composante partielle $(t_1, t_2)$ prédistorsionnées à partir d'un signal de prédistorsion qui est fonction de la composante I (i) et de la composante Q (q) et qui présente une première composante de prédistorsion $(p_1)$ et une deuxième composante de prédistorsion $(p_2)$, la prédistorsion s'effectuant de manière que soit choisie, comme première composante partielle $(t_1)$ prédistorsionnée du signal porteur, alternativement dans le temps, la première et la deuxième composante de prédistorsion $(p_1, p_2)$, dans un groupe de quatre composantes de prédistorsion choisies successives dans le temps pour la première composante partielle $(t_1)$ prédistorsionnée du signal porteur étant inversé le signe de la deuxième et de la troisième composante de prédistorsion choisie du groupe, et la prédistorsion étant, par ailleurs, effectuée de manière que soit choisie, comme deuxième composante partielle ($t_2$) prédistorsionnée du signal porteur, alternativement dans le temps, la deuxième et la première composante de prédistorsion ($p_2$, $p_1$), dans un groupe de quatre composantes de prédistorsion choisies successives dans le temps pour la deuxième composante partielle ($t_2$) prédistorsionnée du signal porteur étant inversé le signe de la troisième et de la quatrième composante de prédistorsion choisie du groupe, et la première composante partielle ($t_1$) prédistorsionnée du signal porteur étant, à un moment, égale à la composante de prédistorsion à laquelle n'est pas égale la deuxième composante partielle ($t_2$) prédistorsionnée du signal porteur.

Fig. 1A

Fig. 1B

Fig. 1C

Fig. 2

Fig. 3

Fig. 4

Fig. 5A

Fig. 5B

Fig. 5C

<u>**600**</u>

**Fig. 6**